# EUROPEAN PATENT SPECIFICATION

(11) **EP 3 330 799 B1**
(45) Date of publication and mention of the grant of the patent: **04.03.2020**
(21) Application number: 17196156.8
(22) Date of filing: 25.12.2013
(51) Int. Cl.: G03F 7/20, H01L 21/027

(54) **EXPOSURE APPARATUS, EXPOSING METHOD AND DEVICE MANUFACTURING METHOD**
BELICHTUNGSAPPARAT, BELICHTUNGSVERFAHREN UND VERFAHREN ZUR HERSTELLUNG EINER VORRICHTUNG
APPAREIL D'EXPOSITION, PROCÉDÉ D'EXPOSITION ET PROCÉDÉ DE FABRICATION D'UN DISPOSITIF

(30) Priority: 27.12.2012 JP 2012285783
(43) Date of publication of application: 06.06.2018
(62) Divisional of application: 13867127.6
(73) Proprietor: Nikon Corporation, Minato-ku, Tokyo 108-6290 (JP)
(72) Inventor: Sato, Shinji, Tokyo 100-8331 (JP); Matsumura, Nobutaka, Tokyo 100-8331 (JP)
(74) Representative: Hoffmann Eitle

(56) References cited:
- US-A1- 2007 296 939

## Description

### [Technical Field]

The present invention relates to an exposure apparatus, an exposing method, and a device manufacturing method.

This application claims priority based on Japan Patent Application No. 2012-285783, filed December 27, 2012.

### [Background Art]

For example, in an exposure apparatus which is used in a photolithography process, a liquid immersion exposure apparatus is known, which exposes a substrate with exposure light via a liquid as disclosed in Patent Document 1.

### [Related Art Document]

### [Patent Document]

[Patent Document 1] United States Patent No. 7,864,292

### [Summary]

### [Problems to be Solved by the Invention]

In the exposure apparatus, when vibrations occur, exposure failure may occur. As a result, a defective device may be generated.

An object of an aspect of the present invention is to provide an exposure apparatus and an exposing method that are capable of suppressing occurrences of exposure failure. Moreover, an object of another aspect of the present invention is to provide a device manufacturing method that is capable of suppressing occurrences of defective devices.

### [Means for Solving the Problems]

According to a first aspect of the present disclosure, there is provided an exposure apparatus that exposes a substrate with exposure light via a liquid, the exposure apparatus including: an optical member having an emitting surface from which the exposure light is emitted; a liquid immersion member that is disposed at at least a portion of surrounding of an optical path of the exposure light, that is configured to form a liquid immersion space of the liquid on an object movable at below the optical member, and that has a movable member including a recovery part and a first channel, the recovery part being configured to recover at least a portion of the liquid in the liquid immersion space, the first channel being configured to flow the liquid from the recovery part; and a deformation member (i) that is connected to the movable member, (ii) that has a second channel configured to flow the liquid from the first channel, and (iii) that has at least a portion which is deformable.

According to a second aspect of the present disclosure, there is provided an exposure apparatus which exposes a substrate with exposure light via a liquid, the exposure apparatus including: an optical member having an emitting surface from which the exposure light is emitted; a liquid immersion member that is disposed at at least a portion of surrounding of an optical path of the exposure light, that is configured to form a liquid immersion space of the liquid on an object movable at below the optical member, and that has a movable member including a recovery part and a first channel, the recovery part being configured to recover at least a portion of the liquid in the liquid immersion space, the first channel being configured to flow the liquid from the recovery part; and a connecting device (i) that is configured to have at least a portion thereof which faces the movable member, (iii) that has a second channel configured to flow the liquid from the first channel, and (iii) that is configured to have at least a portion thereof which is relatively movable with respect to the movable member, wherein the first channel is connected to a third channel via the second channel, the third channel being in communication with a liquid recovery apparatus.

According to a third aspect of the present disclosure, there is provided a device manufacturing method including: exposing a substrate using the exposure apparatus according to any one of the first and second aspects; and developing the exposed substrate.

According to a fourth aspect of the present disclosure, there is provided an exposing method of exposing a substrate with exposure light via a liquid between an emitting surface of an optical member and the substrate, the exposing method including: forming a liquid immersion space of the liquid on the substrate movable below the optical member by using a liquid immersion member (i) that is disposed at at least surrounding of an optical path of the exposure light, (ii) that is configured to form the liquid immersion space of the liquid on an object movable at below the optical member, and (iii) that comprisies a movable member which comprises a recovery part configured to recover at least a portion of the liquid in the liquid immersion space, and a first channel configured to flow the liquid from the recovery part; exposing the substrate with the exposure light emitted from the emitting surface via the liquid in the liquid immersion space; moving the movable member in at least a part of the exposure processing of the substrate; and recovering the liquid recovered from the recovery part and flowing through the first channel via a second channel of a deformation member connected to the movable member and at least a portion of which is deformable.

According to a fifth aspect of the present disclosure, there is provided an exposing method of exposing a substrate with exposure light via a liquid between an emitting surface of an optical member and the substrate, the exposing method including: forming a liquid immersion space of the liquid on the substrate movable below the optical member by using a liquid immersion member (i) that is disposed at at least surrounding of an optical path of the exposure light, (ii) that is configured to form the liquid immersion space of the liquid on an object movable at below the optical member, and (iii) that comprisies a movable member which comprises a recovery part configured to recover at least a portion of the liquid in the liquid immersion space, and a first channel configured to flow the liquid from the recovery part; exposing the substrate with the exposure light emitted from the emitting surface via the liquid in the liquid immersion space; moving the movable member in at least a part of the exposure processing of the substrate; and recovering the liquid recovered from the recovery part and flowing through the first channel by a liquid recovery apparatus via a second channel of a connection device and a third channel which is connected to the first channel via the second channel, the connection device being configured to have at least a portion thereof facing the movable member and configured to have at least a portion thereof relatively movable with respect to the movable member.

According to a sixth aspect of the present disclosure, there is provided a device manufacturing method comprising: exposing a substrate using the exposing method according to any one of the fourth and fifth aspects, and developing the exposed substrate.

According to a seventh aspect of the present disclosure, there is provided a program that causes a computer to execute control of a liquid immersion exposure apparatus which exposes a substrate with exposure light via a liquid between an emitting surface of an optical member and the substrate, wherein the program performs: forming a liquid immersion space of the liquid on the substrate movable below the optical member by using a liquid immersion member (i) that is disposed at at least surrounding of an optical path of the exposure light, (ii) that is configured to form the liquid immersion space of the liquid on an object movable at below the optical member, and (iii) that comprisies a movable member which comprises a recovery part configured to recover at least a portion of the liquid in the liquid immersion space, and a first channel configured to flow the liquid from the recovery part; exposing the substrate with the exposure light emitted from the emitting surface via the liquid in the liquid immersion space; moving the movable member in at least a part of the exposure processing of the substrate; and recovering the liquid recovered from the recovery part and flowing through the first channel via a second channel of a deformation member connected to the movable member and at least a portion of which is deformable.

According to an eighth aspect of the present disclosure, there is provided a program that causes a computer to execute control of a liquid immersion exposure apparatus which exposes a substrate with exposure light via a liquid between an emitting surface of an optical member and the substrate, wherein the program performs: forming a liquid immersion space of the liquid on the substrate movable below the optical member by using a liquid immersion member (i) that is disposed at at least surrounding of an optical path of the exposure light, (ii) that is configured to form the liquid immersion space of the liquid on an object movable at below the optical member, and (iii) that comprisies a movable member which comprises a recovery part configured to recover at least a portion of the liquid in the liquid immersion space, and a first channel configured to flow the liquid from the recovery part; exposing the substrate with the exposure light emitted from the emitting surface via the liquid in the liquid immersion space; moving the movable member in at least a part of the exposure processing of the substrate; and recovering the liquid recovered from the recovery part and flowing through the first channel by a liquid recovery apparatus via a second channel of a connection device and a third channel connected to the first channel via the second channel, the connection device being configured to have at least a portion thereof which faces the movable member and being configured to have at least a portion thereof which is relatively movable with respect to the movable member.

According to a ninth aspect of the present disclosure, there is provided a computer-readable recording medium on which the program according to any one of the seventh and eighth aspects is recorded.

According to an aspect of the invention, there is provided an exposure apparatus as defined in claims 1 and 8. According to another aspect of the invention, there is provided an exposure method as defined in claims 23 and 24.

According to yet another aspect of the invention, there is provided a device manufacturing method as defined in claim 25.

### [Advantage of the Invention]

According to the aspects of the present invention, occurrence of exposure failure can be suppressed. In addition, according to the aspects of the present invention, occurrence of a defective device can be suppressed.

### [Brief Description of Drawings]

Fig. 1 is a view showing an example of an exposure apparatus according to a first embodiment.
Fig. 2 is a side cross-sectional view showing an example of a liquid immersion member according to the first embodiment.
Fig. 3 is a side cross-sectional view showing a portion of the liquid immersion member according to the first embodiment.
Fig. 4 is a view showing an example of an operation of the liquid immersion member according to the first embodiment.
Fig. 5 is a view showing the liquid immersion member according to the first embodiment when seen from below.
Fig. 6 is an exploded perspective view showing an example of the liquid immersion member according to the first embodiment.
Fig. 7 is an exploded perspective view showing an example of the liquid immersion member according to the first embodiment.
Fig. 8 is a view showing an example of a support apparatus according to the first embodiment.
Fig. 9 is a view showing an example of the support apparatus according to the first embodiment.
Fig. 10 is a view showing an example of the support apparatus according to the first embodiment.
Fig. 11 is a view showing an example of the support apparatus according to the first embodiment.
Fig. 12 is a view showing an example of a piping system according to the first embodiment.
Fig. 13 is a view for describing an example of an operation of the exposure apparatus according to the first embodiment.
Fig. 14 is a schematic diagram for describing an example of the operation of the exposure apparatus according to the first embodiment.
Fig. 15 is a schematic diagram for describing an example of an operation of the liquid immersion member according to the first embodiment.
Fig. 16 is a view showing an example of a piping system according to a second embodiment.
Fig. 17 is a view showing an example of a piping system according to a third embodiment.
Fig. 18 is a view showing an example of a piping system according to a fourth embodiment.
Fig. 19 is a view showing an example of a piping system according to a fifth embodiment.
Fig. 20 is a view showing an example of a connection device according to a sixth embodiment.
Fig. 21 is a view showing an example of a connection device according to a seventh embodiment.
Fig. 22 is a view showing an example of a connection device according to an eighth embodiment.
Fig. 23 is a view showing an example of the connection device according to the eighth embodiment.
Fig. 24 is a view showing an example of the liquid immersion member.
Fig. 25 is a view showing an example of the liquid immersion member.
Fig. 26 is a view showing an example of a substrate stage.
Fig. 27 is a flowchart for describing an example of a method of manufacturing a device.

### [Description of Embodiments]

Hereinafter, embodiments of the present invention will be described with reference to the accompanying drawings. However, the present invention is not limited thereto. In the description below, an XYZ Cartesian coordinate system is set, and a positional relation of each part will be described with reference to the XYZ Cartesian coordinate system. A predetermined direction in a horizontal plane is set to an X axis direction, a direction orthogonal to the X axis direction in the horizontal plane is set to a Y axis direction, and a direction (i.e., a vertical direction) orthogonal to each of the X axis direction and the Y axis direction is set to a Z axis direction. Moreover, the rotation (inclination) directions around the X axis, the Y axis, and the Z axis are set to the θX, θY, and θZ directions.

### <First embodiment>

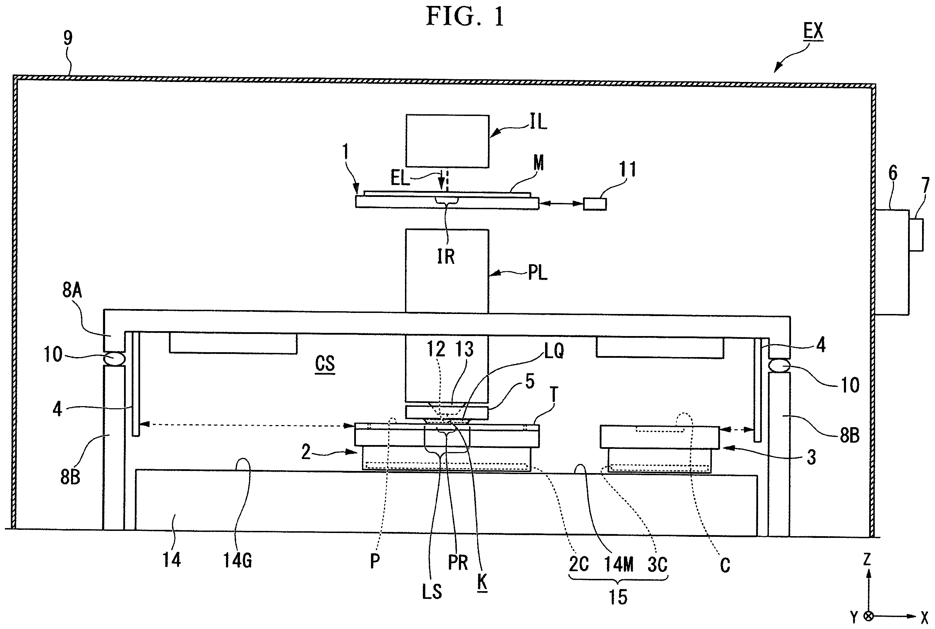

A first embodiment will be described. Fig. 1 is a schematic configuration view showing an example of an exposure apparatus EX according to the first embodiment. The exposure apparatus EX of the embodiment is a liquid immersion exposure apparatus that exposes a substrate P to exposure light EL via a liquid LQ. In the embodiment, a liquid immersion space LS is formed so that an optical path K of the exposure light EL which is radiated to the substrate P is filled with the liquid LQ. The liquid immersion space LS is a portion (a space, a region) which is filled with the liquid. The substrate P is exposed to the exposure light EL via the liquid LQ in the liquid immersion space LS. In the embodiment, water (pure water) is used as the liquid LQ.

For example, the exposure apparatus EX of the embodiment is an exposure apparatus including a substrate stage and a measurement stage as disclosed in United States Patent No. 6897963, European Patent Application, Publication No. 1713113, or the like.

In Fig. 1, the exposure apparatus EX includes a mask stage 1 which is movable while holding a mask M, a substrate stage 2 which is movable while holding the substrate P, a measurement stage 3 which does not hold the substrate P and which is movable while a measurement member (a measurement instrument) C which measures the exposure light EL is mounted thereon, a measurement system 4 that measures positions of the substrate stage 2 and the measurement stage 3, an illumination system IL which illuminates the mask M with the exposure light EL, projection optical system PL which projects an image of a pattern of the mask M which is illuminated with the exposure light EL to the substrate P, a liquid immersion member 5 which forms the liquid immersion space LS of the liquid LQ, a controller 6 which controls an operation of the entire exposure apparatus EX, and a storage device 7 which is connected to the controller 6 and stores various information with respect to the exposure.

Moreover, the exposure apparatus EX includes a reference frame 8A which supports the projection optical system PL and various measurement systems including the measurement system 4, an apparatus frame 8B which supports the reference frame 8A, and a vibration isolator 10 which is disposed between the reference frame 8A and the apparatus frame 8B, and suppresses the transmission of vibrations from the apparatus frame 8B to the reference frame 8A. The vibration isolator 10 includes a spring apparatus or the like. In the embodiment, vibration isolator 10 includes a gas spring (for example, an air mount). Further, either a detection system which detects an alignment mark of the substrate P or a detection system which detects the position of the surface of an object such as the substrate P, or both detection systems may be supported by the reference frame 8A.

In addition, the exposure apparatus EX includes a chamber apparatus 9 which adjusts an environment (at least one of temperature, humidity, pressure, and a degree of cleanliness) of a space CS to which the exposure light EL advances. At least the projection optical system PL, the liquid immersion member 5, the substrate stage 2, and the measurement stage 3 are disposed in the space CS. In the embodiment, at least a portion of the mask stage 1 and the illumination system IL is also disposed in the space CS.

The mask M includes a reticle on which a device pattern projected to the substrate P is formed. For example, the mask M includes a transmission type mask which includes a transparent plate such as a glass plate, and a pattern formed on the transparent plate using a light-shielding material such as chromium or the like. Moreover, a reflection type mask may be used as the mask M.

The substrate P is a substrate used to manufacture a device. For example, the substrate P includes a base material such as a semiconductor wafer or the like and a photosensitive film which is formed on the base material. The photosensitive film is a film of a photosensitive material (photoresist). Moreover, the substrate P may include other films in addition to the photosensitive film. For example, the substrate P may include an anti-reflective film, and may include a protective film (a top coat film) which protects the photosensitive film.

The illumination system IL radiates the exposure light EL to an illumination region IR. The illumination region IR includes positions which can be irradiated with the exposure light EL emitted from the illumination system IL. The illumination system IL illuminates at least a portion of the mask M disposed in the illumination region IR with the exposure light EL having a uniform illumination distribution. For example, as for the exposure light EL which is emitted from the illumination system IL, far-ultraviolet light (DUV light) such as a bright line (g-line, h-line, i-line) emitted from a mercury lamp and KrF excimer laser light (wavelength of 248 nm), ArF excimer laser light (wavelength of 193 nm), vacuum-ultraviolet light (VUV light) such as F₂ laser light (wavelength of 157 nm), and the like are used. In the embodiment, as the exposure light EL, ArF excimer laser light, which is ultraviolet light (vacuum-ultraviolet light), is used.

The mask stage 1 is movable while holding the mask M. For example, the mask stage 1 is moved by an operation of a driving system 11 which includes a planar motor as disclosed in United States Patent No. 6452292. In the present embodiment, the mask stage 1 is able to move in six directions including the X axis, the Y axis, the Z axis, the θX, the θY, and the θZ directions due to the operation of the driving system 11. Moreover, the driving system 11 may not include a planar motor. The driving system 11 may include a linear motor.

The projection optical system PL radiates the exposure light EL to a projection region PR. The projection region PR includes positions which can be irradiated with the exposure light EL emitted from the projection optical system PL. The projection optical system PL projects the image of the pattern of the mask M on at least a portion of the substrate P disposed in the projection region PR with a predetermined projection magnification. In the embodiment, the projection optical system PL is a reduction system. The projection magnification of the projection optical system PL is 1/4. Further, the projection magnification of the projection optical system PL may be 1/5, 1/8, or the like. Moreover, the projection optical system PL may be either a unit magnification system or an enlargement system. In the embodiment, the optical axis of the projection optical system PL is parallel to the Z axis. The projection optical system PL may be any of a refraction system which does not include a reflective optical element, a reflection system which does not include a refractive optical element, or a reflective refraction system which includes the reflective optical element and the refractive optical element. The projection optical system PL may form either an inverted image or an upright image.

The projection optical system PL includes a terminal optical element 13 which includes an emitting surface 12 from which the exposure light EL is emitted. The emitting surface 12 emits the exposure light EL toward the image surface of the projection optical system PL. The terminal optical element 13 is an optical element nearest to the image surface of the projection optical system PL among the plurality of optical elements of the projection optical system PL. The projection region PR includes positions which can be irradiated with the exposure light EL emitted from the emitting surface 12. In the embodiment, the emitting surface 12 faces the -Z direction. The exposure light EL emitted from the emitting surface 12 advances in the -Z axis direction. The emitting surface 12 is parallel to the XY plane. Moreover, the emitting surface 12 facing the -Z axis direction may have a convex surface or a concave surface. In addition, the emitting surface 12 may be inclined with respect to the XY plane and may include a curved surface. In the embodiment, the optical axis of the terminal optical element 13 is parallel to the Z axis.

With respect to the direction parallel to the optical axis of the terminal optical element 13, the emitting surface 12 side is at the -Z side, and the incident surface side is at the +Z side. With respect to the direction parallel to the optical axis of the projection optical system PL, the image surface side of the projection optical system PL is at the -Z side, and the object surface side of the projection optical system PL is at the +Z side.

The substrate stage 2 is able to move in the XY plane, which includes positions (the projection region PR) which can be irradiated with the exposure light EL from the emitting surface 12, in a state in which the substrate stage holds the substrate P. The measurement stage 3 is able to move in the XY plane, which includes positions (the projection region PR) which can be irradiated with the exposure light EL from the emitting surface 12, in a state in which a measurement member (measurement instrument) C is mounted on the measurement stage. Each of the substrate stage 2 and the measurement stage 3 is able to move on a guide surface 14G of a base member 14. The guide surface 14G and the XY plane are substantially parallel to each other.

The substrate stage 2 includes a first holding part which releasably holds the substrate P and a second holding part which is disposed at the surrounding of the first holding part and releasably holds a cover member T as disclosed in, for example, United States Patent Application, Publication No. 2007/0177125, United States Patent Application, Publication No. 2008/0049209, and the like. The first holding part holds the substrate P so that the surface (upper surface) of the substrate P and the XY plane are substantially parallel to each other. The upper surface of the substrate P held by the first holding part and the upper surface of the cover member T held by the second holding part are disposed in substantially the same plane.

With respect to the Z axis direction, the distance between the emitting surface 12 and the upper surface of the substrate P held by the first holding part is substantially the same as the distance between the emitting surface 12 and the upper surface of the cover member T held by the second holding part.

Further, with respect to the Z axis direction, the distance between the emitting surface 12 and the upper surface of the substrate P being substantially the same as the distance between the emitting surface 12 and the upper surface of the cover member T includes a difference of the distance between the emitting surface 12 and the upper surface of the substrate P and the distance between the emitting surface 12 and the upper surface of the cover member T being within, for example, 10% of the distance (a so-called working distance) between the emitting surface 12 and the upper surface of the substrate P when the substrate P is exposed. Moreover, the upper surface of the substrate P held by the first holding part and the upper surface of the cover member T held by the second holding part may not be disposed on substantially the same plane. For example, with respect to the Z axis direction, the position of the upper surface of the substrate P and the position of the upper surface of the cover member T may be different from each other. For example, there may be a step between the upper surface of the substrate P and the upper surface of the cover member T. Moreover, the upper surface of the cover member T may be inclined with respect to the upper surface of the substrate P, and the upper surface of the cover member T may include a curved surface.

The substrate stage 2 and the measurement stage 3 are moved due to an operation of a driving system 15 which includes a planar motor as disclosed in, for example, United States Patent No. 6452292. The driving system 15 includes a mover 2C which is disposed at the substrate stage 2, a mover 3C which is disposed at the measurement stage 3, and a stator 14M which is disposed at the base member 14. Each of the substrate stage 2 and the measurement stage 3 is able to move on the guide surface 14G in six directions including the X axis, the Y axis, the Z axis, the θX, the θY, and the θZ directions due to the operation of the driving system 15. Moreover, the driving system 15 may not include a planar motor. The driving system 15 may include a linear motor.

The measurement system 4 includes an interferometer system. The interferometer system includes a unit which radiates measurement light to a measurement mirror of the substrate stage 2 and a measurement mirror of the measurement stage 3 and measures the positions of the substrate stage 2 and the measurement stage 3. In addition, for example, the measurement system may include an encoder system disclosed in United States Patent Application, Publication No. 2007/0288121. Moreover, the measurement system 4 may include only one of the interferometer system and the encoder system.

When exposure processing of the substrate P is performed, or when predetermined measurement processing is performed, the controller 6 performs position controls of the substrate stage 2 (the substrate P) and the measurement stage 3 (the measurement member C) based on the measurement results of the measurement system 4.

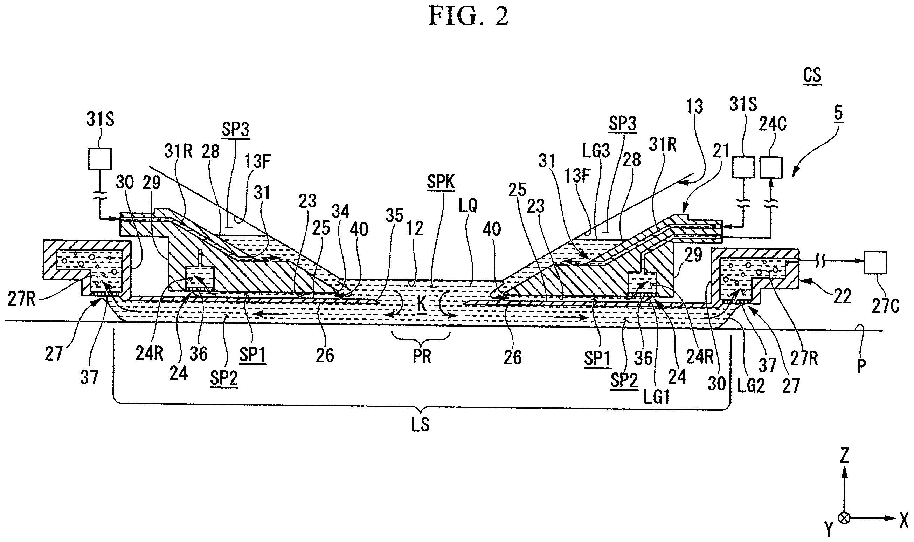

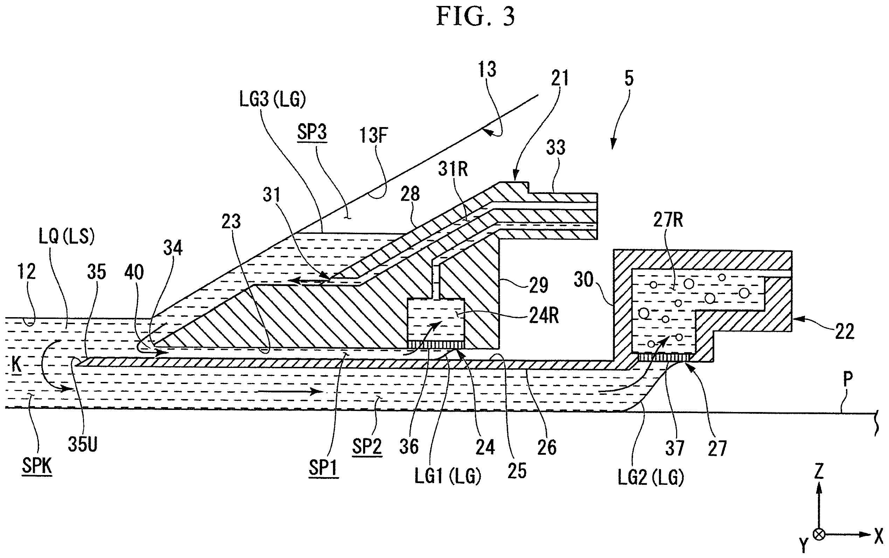

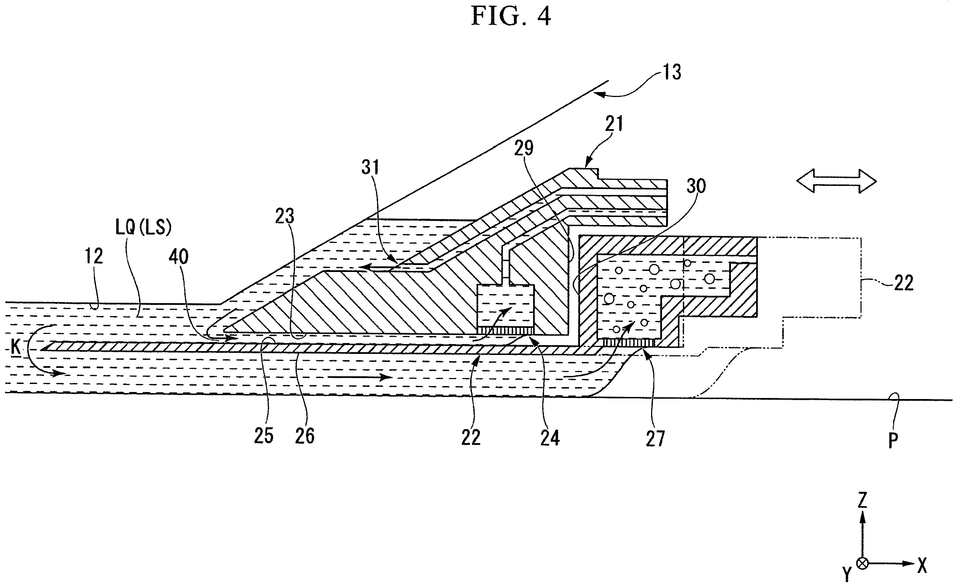

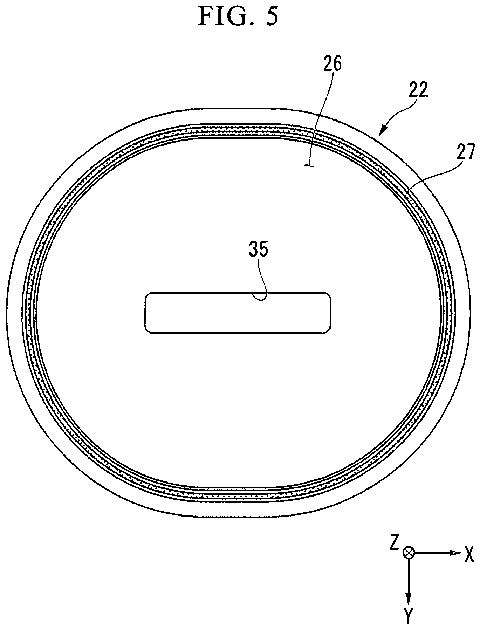

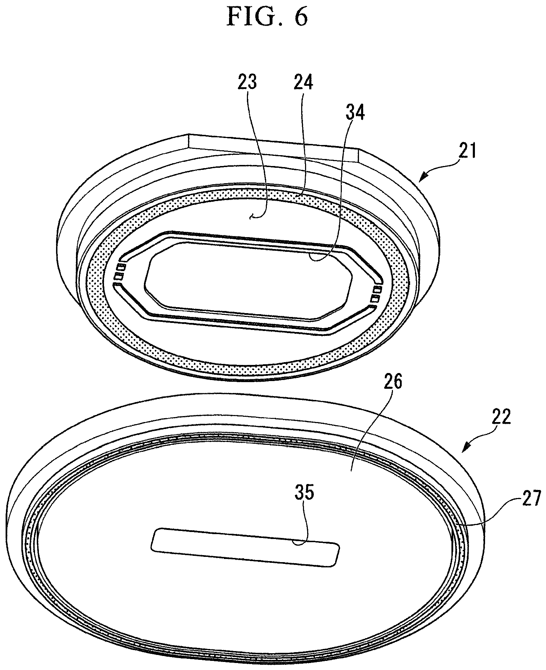

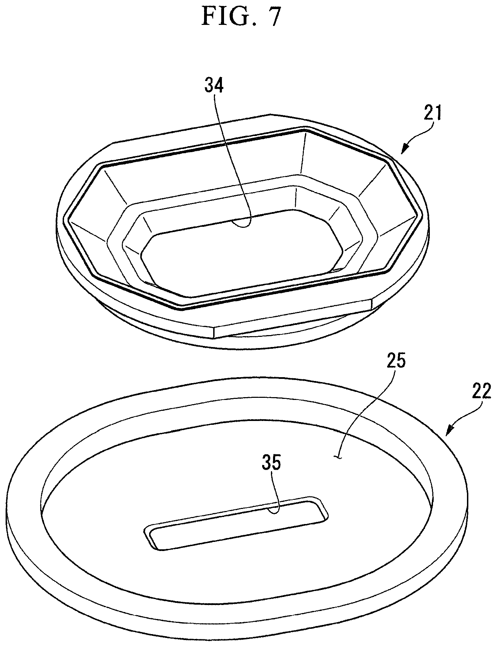

Next, the liquid immersion member 5 according to the embodiment will be described. In addition, the liquid immersion member may also be referred to as a nozzle member. Fig. 2 is a cross-sectional view of the liquid immersion member 5 parallel to the XZ plane. Fig. 3 is an enlarged view of a portion of Fig. 2. Fig. 4 is a view showing an example of an operation of the liquid immersion member 5. Fig. 5 is a view of the liquid immersion member 5 when seen from below (the -Z side). Figs. 6 and 7 are exploded perspective views of the liquid immersion member 5.

The liquid immersion member 5 forms the liquid immersion space LS of the liquid LQ above the object which is movable below the terminal optical element 13.

The object which is movable below the terminal optical element 13 is able to move in the XY plane which includes the position opposite to the emitting surface 12. The object may be opposite the emitting surface 12 and is able to be disposed in the projection region PR. The object is able to move below the liquid immersion member 5 and may be opposite the liquid immersion member 5.

In the embodiment, the object includes at least one of at least a portion of the substrate stage 2 (for example, the cover member T of the substrate stage 2), the substrate P which is held by the substrate stage 2 (the first holding part), and the measurement stage 3.

In the exposure of the substrate P, the liquid immersion space LS is formed so that the optical path K of the exposure light EL between the emitting surface 12 of the terminal optical element 13 and the substrate P is filled with the liquid LQ. When the exposure light EL is radiated to the substrate P, the liquid immersion space LS is formed so that only a portion of the surface region of the substrate P which includes the projection region PR is covered by the liquid LQ.

In the descriptions below, the object is defined as the substrate P. Moreover, as described above, the object may be at least one of the substrate stage 2 and the measurement stage 3, and the object may be one other than the substrate P, the substrate stage 2, and the measurement stage 3.

The liquid immersion space LS may be formed over two objects. For example, the liquid immersion space LS may be formed over the cover member T of the substrate stage 2 and the substrate P. The liquid immersion space LS may be formed over the substrate stage 2 and the measurement stage 3.

The liquid immersion space LS is formed so that the optical path K of the exposure light EL emitted from the emitting surface 12 of the terminal optical element 13 is filled with the liquid LQ. At least a portion of the liquid immersion space LS is formed in a space between the terminal optical element 13 and the substrate P (the object). At least a portion of the liquid immersion space LS is formed in a space between the liquid immersion member 5 and the substrate P (the object).

The liquid immersion member 5 includes a first member 21 disposed at at least a portion of the surrounding of the terminal optical element 13, and a second member 22 disposed at at least a portion of the surrounding of the optical path K below the first member 21. The second member 22 is movable with respect to the first member 21. The second member 22 is disposed so that the substrate P (the object) can be opposite thereto.

The first member 21 is disposed at a position farther away from the substrate P (the object) than the second member 22. At least a portion of the second member 22 is disposed between the first member 21 and the substrate P (the object). At least a portion of the second member 22 is disposed between the terminal optical element 13 and the substrate P (the object).

The first member 21 has a lower surface 23 which faces the -Z axis direction, and a fluid recovery part 24 which is disposed at at least a portion of the surrounding of the lower surface 23 and is able to recover the liquid LQ. The second member 22 has an upper surface 25 which faces the +Z axis direction, a lower surface 26 which faces in the -Z axis direction, and a fluid recovery part 27 which is disposed at at least a portion of the surrounding of the lower surface 26. The fluid recovery part 24 recovers at least a portion of the liquid LQ in the liquid immersion space LS. The fluid recovery part 27 recovers at least a portion of the liquid LQ in the liquid immersion space LS.

The first member 21 has an inner side surface 28 opposite to a side surface 13F of the terminal optical element 13, and an outer side surface 29 directed outward with respect to the optical path K (an optical axis of the terminal optical element 13). The second member 22 has an inner side surface 30 opposite to the outer side surface 29 via a gap.

The inner side surface 28 of the first member 21 is opposite to the side surface 13F of the terminal optical element 13 via a gap.

The second member 22 is capable of being opposite to the lower surface 23. The second member 22 is capable of being opposite to the fluid recovery part 24. At least a portion of the upper surface 25 of the second member 22 is opposite to the lower surface 23 via a gap. At least a portion of the upper surface 25 is opposite the emitting surface 12 via a gap.

The substrate P (the object) may be opposite the lower surface 26. The substrate P (the object) may be opposed to at least a portion of the fluid recovery part 27. At least a portion of the upper surface of the substrate P is opposite the lower surface 26 via a gap. At least a portion of the upper surface of the substrate P is opposite the emitting surface 12 via a gap.

A first space SP1 is formed between the lower surface 23, the lower surface of the fluid recovery part 24 and the upper surface 25.

A second space SP2 is formed between the lower surface 26, the lower surface of the fluid recovery part 27, and the upper surface of the substrate P (the object). A third space SP3 is formed between the side surface 13F and the inner side surface 28.

The side surface 13F of the terminal optical element 13 is disposed at the surrounding of the emitting surface 12. The side surface 13F is a non-emitting surface which does not emit the exposure light EL. The exposure light EL passes through the emitting surface 12 but does not pass through the side surface 13F.

The lower surface 23 of the first member 21 does not recover the liquid LQ. The lower surface 23 serving as the non-recovery part cannot recover the liquid LQ. The lower surface 23 of the first member 21 is able to hold the liquid LQ between the first member 21 and the second member 22.

The upper surface 25 of the second member 22 does not recover the liquid LQ. The upper surface 25 serving as the non-recovery part cannot recover the liquid LQ. The upper surface 25 of the second member 22 is able to hold the liquid LQ between the second member 22 and the first member 21.

The lower surface 26 of the second member 22 does not recover the liquid LQ. The lower surface 26 serving as the non-recovery part cannot recover the liquid LQ. The lower surface 26 of the second member 22 is able to hold the liquid LQ between the second member and the substrate P (the object).

The inner side surface 28, the outer side surface 29, and the inner side surface 30 do not recover the liquid LQ. The inner side surface 28, the outer side surface 29, and the inner side surface 30 serving as the non-recovery parts cannot recover the liquid LQ.

In the embodiment, the lower surface 23 is substantially parallel to the XY plane. The upper surface 25 is also substantially parallel to the XY plane. The lower surface 26 is also substantially parallel to the XY plane. That is, the lower surface 23 and the upper surface 25 are substantially parallel to each other. The upper surface 25 and the lower surface 26 are substantially parallel to each other.

Further, the lower surface 23 may be non-parallel to the XY plane. The lower surface 23 may be inclined with respect to the XY plane, or may include a curved surface.

Further, the upper surface 25 may be non-parallel to the XY plane. The upper surface 25 may be inclined with respect to the XY plane, or may include a curved surface.

Further, the lower surface 26 may be non-parallel to the XY plane. The lower surface 26 may be inclined with respect to the XY plane, or may include a curved surface.

Further, the lower surface 23 and the upper surface 25 may be parallel or non-parallel to each other. The upper surface 25 and the lower surface 26 may be parallel or non-parallel to each other. The lower surface 23 and the lower surface 26 may be parallel or non-parallel to each other.

The first member 21 has an opening 34 through which the exposure light EL emitted from the emitting surface 12 is able to pass. The second member 22 has an opening 35 through which the exposure light EL emitted from the emitting surface 12 is able to pass. A dimension of the opening 34 in the XY plane is larger than a dimension of the opening 35.

In the embodiment, a shape of the opening 35 in the XY plane is a rectangular shape. The opening 35 is elongated in the X axis direction. Further, a shape of the opening 35 may be an elliptical shape elongated in the X axis direction or may be a polygonal shape elongated in the X axis direction.

At least a portion of the terminal optical element 13 is disposed inside the opening 34. The lower surface 23 is disposed at the surrounding of a lower end of the opening 34. The upper surface 25 is disposed at the surrounding of an upper end of the opening 35. The lower surface 26 is disposed at the surrounding of a lower end of the opening 35.

In the embodiment, at least a portion of an inner surface 35U of the second member 22 is inclined upward toward the outside in the radial direction with respect to the optical path K. At least a portion of the inner surface 35U of the second member 22 defines the opening 35 which faces the optical path K. Accordingly, in a state in which the inner surface 35U of the second member 22 is disposed in the liquid immersion space LS, the second member 22 is smoothly movable. In addition, even when the second member 22 is moved in a state in which the inner surface 35U of the second member 22 is disposed in the liquid immersion space LS, a pressure of the liquid LQ in the liquid immersion space LS is suppressed from being fluctuated.

The first member 21 is disposed at the surrounding of the terminal optical element 13. The first member 21 is an annular member. The first member 21 is disposed not to come in contact with the terminal optical element 13. An gap is formed between the first member 21 and the terminal optical element 13. The first member 21 is not opposite to the emitting surface 12.

The second member 22 is disposed at the surrounding of the optical path K of the exposure light EL emitted from the emitting surface 12.

The second member 22 is an annular member. The second member 22 is disposed not to come in contact with the first member 21. A gap is formed between the second member 22 and the first member 21.

The second member 22 is movable with respect to the first member 21. The second member 22 is movable with respect to the terminal optical element 13. A relative position between the second member 22 and the first member 21 is varied. A relative position between the second member 22 and the terminal optical element 13 is varied.

The second member 22 is movable in the XY plane perpendicular to the optical axis of the terminal optical element 13. The second member 22 is movable substantially parallel to the XY plane. As shown in Fig. 4, in the embodiment, the second member 22 is movable at least in the X axis direction. Further, the second member 22 may be movable in at least one direction of the Y axis, Z axis, θX, θY, and θZ directions in addition to the X axis direction.

In the embodiment, the terminal optical element 13 is substantially immobile. The first member 21 is also substantially immobile. The first member 21 is substantially immobile with respect to the terminal optical element 13.

The second member 22 is movable below at least a portion of the first member 21. The second member 22 is movable between the first member 21 and the substrate P (the object).

As the second member 22 is moved in the XY plane, a dimension of the gap between the outer side surface 29 of the first member 21 and the inner side surface 30 of the second member 22 is varied. In other words, as the second member 22 is moved in the XY plane, a size of the space between the outer side surface 29 and the inner side surface 30 is varied. For example, in the example shown in Fig. 4, as the second member 22 is moved in the -X axis direction, a dimension of the gap between the outer side surface 29 and the inner side surface 30 at the +X side with respect to the terminal optical element 13 is reduced (a space between the outer side surface 29 and the inner side surface 30 is reduced). As the second member 22 is moved in the +X axis direction, a dimension of the gap between the outer side surface 29 and the inner side surface 30 at the +X side with respect to the terminal optical element 13 is increased (a space between the outer side surface 29 and the inner side surface 30 is increased).

In the embodiment, a movable range (a moving range) of the second member 22 is determined such that the first member 21 (the outer side surface 29) and the second member 22 (the inner side surface 30) do not come in contact with each other.

The liquid immersion member 5 has a liquid supply part 31 which supplies the liquid LQ to form the liquid immersion space LS. The liquid supply part 31 is disposed at the first member 21.

Further, the liquid supply part 31 may be disposed at both the first member 21 and the second member 22.

Further, the liquid supply part 31 is disposed at the first member 21, and may not be disposed at the second member 22. Further, the liquid supply part 31 is disposed at the second member 22, and may not be disposed at the first member 21. Further, the liquid supply part 31 may be disposed at a member different from the first member 21 and the second member 22.

The fluid recovery part 24 and the fluid recovery part 27 are disposed outside the liquid supply part 31 in the radial direction with respect to the optical path K of the exposure light EL (the optical axis of the terminal optical element 13). In the embodiment, the liquid supply part 31 includes an opening (a liquid supply port) disposed in the inner side surface 28 of the first member 21.

The liquid supply part 31 is disposed opposite the side surface 13F. The liquid supply part 31 supplies the liquid LQ into the third space SP3 between the side surface 13F and the inner side surface 28. In the embodiment, liquid supply parts 31 are disposed at the +X side and the -X side with respect to the optical path K (the terminal optical element 13).

Further, the liquid supply part 31 may be disposed in the Y axis direction with respect to the optical path K (the terminal optical element 13), and the plurality of liquid supply parts 31 may be disposed at the surrounding of the optical path K (the terminal optical element 13) including the X axis direction and the Y axis direction. The number of the liquid supply part 31 may be one. Further, instead of the liquid supply part 31, or in addition to the liquid supply part 31, the liquid supply part that can supply the liquid LQ may be installed at the lower surface 23.

In the embodiment, the liquid supply part (the liquid supply port) 31 is connected to a liquid supply apparatus 31S via a supply channel 31R formed at the first member 21. The liquid supply apparatus 31S can supply the clean liquid LQ, a temperature of which is adjusted, into the liquid supply part 31. The liquid supply part 31 supplies the liquid LQ from the liquid supply apparatus 31S to form the liquid immersion space LS.

An opening 40 is formed between an inner edge of the lower surface 23 and the upper surface 25. An optical path space SPK including the optical path K between the emitting surface 12 and the substrate P (the object) is joined to the first space SP1 between the lower surface 23 and the upper surface 25 via the opening 40. The optical path space SPK includes a space between the emitting surface 12 and the substrate P (the object), and a space between the emitting surface 12 and the upper surface 25. The opening 40 is disposed to face the optical path K. The third space SP3 between the side surface 13F and the inner side surface 28 is joined to the first space SP1 via the opening 40.

At least a portion of the liquid LQ from the liquid supply part 31 is supplied into the first space SP1 between the lower surface 23 and the upper surface 25 via the opening 40. At least a portion of the liquid LQ supplied from the liquid supply part 31 to form the liquid immersion space LS is supplied onto the substrate P (the object) opposite to the emitting surface 12 via the opening 34 and the opening 35. Accordingly, the optical path K is filled with the liquid LQ. At least a portion of the liquid LQ from the liquid supply part 31 is supplied into the second space SP2 between the lower surface 26 and the upper surface of the substrate P (the object).

In the Z axis direction, a dimension of the first space SP1 is smaller than a dimension of the second space SP2. Further, in the Z axis direction, the dimension of the first space SP1 may be substantially equal to the dimension of the second space SP2, or may be larger than the dimension of the second space SP2.

The fluid recovery part 24 is disposed outside the lower surface 23 with respect to the optical path K (the optical axis of the terminal optical element 13). The fluid recovery part 24 is disposed at the surrounding of the lower surface 23. The fluid recovery part 24 is disposed at the surrounding of the optical path K of the exposure light EL. Further, the fluid recovery part 24 may be disposed at a portion of the surrounding of the lower surface 23. For example, a plurality of fluid recovery parts 24 may be disposed at the surrounding of the lower surface 23. The fluid recovery part 24 is disposed to face the first space SP1. The fluid recovery part 24 recovers at least a portion of the liquid LQ of the first space SP1.

The fluid recovery part 27 is disposed outside the lower surface 26 with respect to the optical path K (the optical axis of the terminal optical element 13). The fluid recovery part 27 is disposed outside the lower surface 26 with respect to a center of the opening 35. The fluid recovery part 27 is disposed at the surrounding of the lower surface 26. The fluid recovery part 27 is disposed at the surrounding of the optical path K of the exposure light EL. Further, the fluid recovery part 27 may be disposed at a portion of the surrounding of the lower surface 26. For example, a plurality of fluid recovery parts 27 may be disposed at the surrounding of the lower surface 26. The fluid recovery part 27 is disposed to face the second space SP2. The fluid recovery part 27 recovers at least a portion of the liquid LQ of the second space SP2.

The fluid recovery part 27 is disposed outside the first member 21 with respect to the optical path K (the optical axis of the terminal optical element 13). The fluid recovery part 27 is disposed outside the first space SP1 with respect to the optical path K (the optical axis of the terminal optical element 13).

In the embodiment, movement of the liquid LQ from one of the first space SP1 at the upper surface 25 side and the second space SP2 at the lower surface 26 side to the other space is suppressed. The first space SP1 and the second space SP2 are partitioned by the second member 22. The liquid LQ in the first space SP1 can move to the second space SP2 via the opening 35. The liquid LQ in the first space SP1 is not able to move to the second space SP2 without passing through the opening 35. The liquid LQ present in the first space SP1 outside the opening 35 with respect to the optical path K is not able to move to the second space SP2. The liquid LQ in the second space SP2 is able to move to the first space SP1 via the opening 35. The liquid LQ of the second space SP2 is not able to move to the first space SP1 without passing through the opening 35. The liquid LQ present in the second space SP2 outside the opening 35 with respect to the optical path K is not able to move to the first space SP1. That is, in the embodiment, the liquid immersion member 5 does not have a channel, which fluidly connects the first space SP1 and the second space SP2, except for the opening 35.

In the embodiment, the fluid recovery part 27 recovers at least a portion of the liquid LQ in the second space SP2, and does not recover the liquid LQ in the first space SP1. The fluid recovery part 24 recovers at least a portion of the liquid LQ of the first space SP1, and does not recover the liquid LQ of the second space SP2.

In addition, the liquid LQ that has moved to the outside of the first space SP1 (the outside of the outer side surface 29) with respect to the optical path K is suppressed from being moved to above the substrate P (the second space SP2) by the inner side surface 30.

The fluid recovery part 24 includes an opening (a fluid recovery port) disposed in at least a portion of the surrounding of the lower surface 23 of the first member 21. The fluid recovery part 24 is disposed opposite the upper surface 25. The fluid recovery part 24 is connected to a fluid recovery apparatus 24C via a recovery channel (space) 24R formed inside the first member 21. The fluid recovery apparatus 24C may be connected to the fluid recovery part 24 and a vacuum system (not shown). The fluid recovery part 24 is able to recover at least a portion of the liquid LQ of the first space SP1. At least a portion of the liquid LQ of the first space SP1 is able to flow into the recovery channel 24R via the fluid recovery part 24. The liquid LQ from the fluid recovery part 24 is able to flow through the recovery channel 24R.

In the embodiment, the fluid recovery part 24 includes a porous member 36, and the fluid recovery port includes holes of the porous member 36. In the embodiment, the porous member 36 includes a mesh plate. The porous member 36 has a lower surface to which the upper surface 25 may face, an upper surface which faces the recovery channel 24R, and a plurality of holes which connect the lower surface and upper surface. The fluid recovery part 24 recovers the liquid LQ via the holes of the porous member 36. The liquid LQ in the first space SP1 recovered from the fluid recovery part 24 (the holes of the porous member 36) flows into the recovery channel 24R, flows through the recovery channel 24R, and is recovered by the fluid recovery apparatus 24C.

In the embodiment, only the liquid LQ is substantially recovered via the fluid recovery part 24, and recovery of a gas GS is limited. The controller 6 adjusts a difference between a pressure (a pressure in the first space SP1) at the lower surface side of the porous member 36 and a pressure (a pressure in the recovery channel 24R) at the upper surface side such that the liquid LQ in the first space SP1 passes through the holes of the porous member 36 to flow into the recovery channel 24R and the gas GS does not pass through the holes. Further, for example, an example of the technology, which recovers only the liquid via the porous member, is disclosed in United States Patent No. 7,292,313 or the like.

Further, both of the liquid LQ and the gas GS may be recovered (suctioned) via the porous member 36. Further, the porous member 36 may not be provided at the first member 21. That is, a fluid (one or both of the liquid LQ and the gas GS) in the first space SP1 may be recovered without passing through the porous member.

In the embodiment, the lower surface of the fluid recovery part 24 includes a lower surface of the porous member 36. The lower surface of the fluid recovery part 24 is disposed at the surrounding of the lower surface 23. In the embodiment, the lower surface of the fluid recovery part 24 is substantially parallel to the XY plane. In the embodiment, the lower surface of the fluid recovery part 24 and the lower surface 23 are disposed in the same plane (flush with each other).

Further, the lower surface of the fluid recovery part 24 may be disposed on the +Z side or the -Z side of the lower surface 23. Further, the lower surface of the fluid recovery part 24 may be inclined with respect to the lower surface 23, or may include a curved surface.

Further, the fluid recovery part 24 configured to recover the fluid (one or both of the liquid LQ and the gas GS) of the first space SP1 may be disposed at the second member 22 to face the first space SP1.

The fluid recovery parts 24 may be disposed at both of the first member 21 and the second member 22. The fluid recovery part 24 may be disposed at the first member 21 but may not be disposed at the second member 22. The fluid recovery part 24 may be disposed at the second member 22 but may not be disposed at the first member 21.

The fluid recovery part 27 includes an opening (a fluid recovery port) which is disposed in at least a portion of the surrounding of the lower surface 26 of the second member 22. The fluid recovery part 27 is disposed opposite the upper surface of the substrate P (the object). The fluid recovery part 27 is connected to a fluid recovery apparatus 27C via a recovery channel (space) 27R formed inside the second member 22. The fluid recovery apparatus 27C may be connected to the fluid recovery part 27 and a vacuum system (not shown). The fluid recovery part 27 is able to recover at least a portion of the liquid LQ of the second space SP2. At least a portion of the liquid LQ of the second space SP2 is able to flow into the recovery channel 27R via the fluid recovery part 27. The liquid LQ from the fluid recovery part 27 is able to flow through the recovery channel 27R.

In the embodiment, the fluid recovery part 27 includes a porous member 37, and the fluid recovery port includes holes of the porous member 37. In the embodiment, the porous member 37 includes a mesh plate. The porous member 37 has a lower surface to which the upper surface of the substrate P (the object) may face, an upper surface which faces the recovery channel 27R, and a plurality of holes which connect the lower surface and the upper surface. The fluid recovery part 27 recovers the fluid (one or both of the liquid LQ and the gas GS) via the holes of the porous member 37. The liquid LQ in the second space SP2 recovered from the fluid recovery part 27 (the holes of the porous member 37) flows into the recovery channel 27R, flows through the recovery channel 27R, and is recovered by the fluid recovery apparatus 27C.

The recovery channel 27R is disposed outside the inner side surface 30 with respect to the optical path K (the optical axis of the terminal optical element 13). The recovery channel 27R is disposed over the fluid recovery part 27. As the second member 22 moves, the fluid recovery part 27 and the recovery channel 27R of the second member 22 move outside the outer side surface 29 of the first member 21.

The gas GS is recovered via the fluid recovery part 27 along with the liquid LQ. Further, only the liquid LQ is recovered via the porous member 37 and recovery of the gas GS may be limited. Further, the porous member 37 may not be provided at the second member 22. That is, the fluid (one or both of the liquid LQ and the gas GS) of the second space SP2 may be recovered without passing through the porous member.

In the embodiment, the lower surface of the fluid recovery part 27 includes a lower surface of the porous member 37. The lower surface of the fluid recovery part 27 is disposed at the surrounding of the lower surface 26. In the embodiment, the lower surface of the fluid recovery part 27 is substantially parallel to the XY plane. In the embodiment, the lower surface of the fluid recovery part 27 is disposed on the +Z side of the lower surface 26.

Further, the lower surface of the fluid recovery part 27 and the lower surface 26 may be disposed in the same plane (flush with each other). The lower surface of the fluid recovery part 27 may be disposed on the -Z side of the lower surface 26. The lower surface of the fluid recovery part 27 may be inclined with respect to the lower surface 26, or may include a curved surface.

In the embodiment, as a recovery operation of the liquid LQ from the fluid recovery part 27 is performed while performing a supply operation of the liquid LQ from the liquid supply part 31, the liquid immersion space LS is formed by the liquid LQ between the terminal optical element 13 and the liquid immersion member 5 at one side and the substrate P (the object) at the other side.

In addition, in the embodiment, a recovery operation of the fluid from the fluid recovery part 24 is performed while performing the supply operation of the liquid LQ from the liquid supply part 31 and the recovery operation of the fluid from the fluid recovery part 27.

In the embodiment, a portion of an interface LG of the liquid LQ in the liquid immersion space LS is formed between the second member 22 and the substrate P (the object). A portion of the interface LG of the liquid LQ in the liquid immersion space LS is formed between the first member 21 and the second member 22. A portion of the interface LG of the liquid LQ in the liquid immersion space LS is formed between the terminal optical element 13 and the first member 21.

In the description below, the interface LG of the liquid LQ formed between the first member 21 and the second member 22 is appropriately referred to as a first interface LG1. The interface LG formed between the second member 22 and the substrate P (the object) is appropriately referred to as a second interface LG2. The interface LG formed between the terminal optical element 13 and the first member 21 is appropriately referred to as a third interface LG3.

In the embodiment, the first interface LG1 is formed between the lower surface of the fluid recovery part 24 and the upper surface 25. The second interface LG2 is formed between the lower surface of the fluid recovery part 27 and the upper surface of the substrate P (the object).

In the embodiment, the first interface LG1 is formed between the lower surface of the fluid recovery part 24 and the upper surface 25, and the liquid LQ in the first space SP1 is suppressed from moving to a space outside the fluid recovery part 24 (for example, a space between the outer side surface 29 and the inner side surface 30). The liquid LQ is not present in the space between the outer side surface 29 and the inner side surface 30. The space between the outer side surface 29 and the inner side surface 30 is a gas space.

The space between the outer side surface 29 and the inner side surface 30 is connected to the space CS. In other words, the space between the outer side surface 29 and the inner side surface 30 is open to the atmosphere. When the pressure in the space CS is at the atmospheric pressure, the space between the outer side surface 29 and the inner side surface 30 is open to air. For this reason, the second member 22 is able to smoothly movable. Further, the pressure in the space CS may be higher or lower than the atmospheric pressure.

Next, an example of the operation of the second member 22 will be described. The second member 22 is movable in cooperation with the movement of the substrate P (the object). The second member 22 is movable independent of the substrate P (the object). The second member 22 is movable in parallel with at least a portion of the movement of the substrate P (the object).

The second member 22 may move in parallel with at least a part of a period in which the substrate P (the object) moves. The second member 22 may move in a movement direction of the substrate P (the object). For example, in at least a part of period in which the substrate P moves, the second member 22 may be moved in the movement direction of the substrate P. For example, when the substrate P is moved in one direction (for example, the +X axis direction) in the XY plane, the second member 22 may be moved in the one direction (the +X axis direction) in the XY plane in synchronization with the movement of the substrate P.

The second member 22 may be moved in a state in which the liquid immersion space LS is formed. The second member 22 may be moved in a state in which the second member comes in contact with the liquid LQ in the liquid immersion space LS. The second member 22 may be moved in a state in which the liquid LQ is present in the first space SP1 and the second space SP2. The second member 22 may be moved in parallel with the supply of the liquid LQ from the liquid supply part 31. The second member 22 may be moved in parallel with the recovery of the liquid LQ from the fluid recovery part 24. The second member 22 may be moved in parallel with the recovery of the liquid LQ from the fluid recovery part 27. The second member 22 may be moved in parallel with the supply of the liquid LQ from the liquid supply part 31 and the recovery of the liquid LQ from the fluid recovery part 24 (the fluid recovery part 27).

The second member 22 may be moved in at least a part of a period in which the exposure light EL is emitted from the emitting surface 12.

The second member 22 may be moved in parallel with at least a part of a period in which the substrate P (the object) moves in a state in which the liquid immersion space LS is formed. The second member 22 may be moved in at least a part of a period in which the exposure light EL is emitted from the emitting surface 12 in a state in which the liquid immersion space LS is formed.

The second member 22 may move when the second member 22 and the substrate P (the object) are not opposite each other. For example, the second member 22 may move when the object is not present under the second member 22. Further, the second member 22 may move when the liquid LQ is not present in the space between the second member 22 and the substrate P (the object). For example, the second member 22 may move when the liquid immersion space LS is not formed.

In the embodiment, for example, the second member 22 moves based on movement conditions of the substrate P (the object). For example, the controller 6 moves the second member 22 in parallel with at least a portion of the movement of the substrate P (the object) based on the movement conditions of the substrate P (the object). The controller 6 moves the second member 22 while performing the supply of the liquid LQ from the liquid supply part 31 and the recovery of the liquid LQ from the fluid recovery part 27 and the fluid recovery part 24 so that the liquid immersion space LS is continuously formed.

In the embodiment, the second member 22 is movable so that a relative movement between the second member 22 and the substrate P (the object) is decreased. The second member 22 is movable so that the relative movement between the second member 22 and the substrate P (the object) becomes smaller than the relative movement between the terminal optical element 13 and the substrate P (the object).

The second member 22 is movable so that a relative movement between the second member 22 and the substrate P (the object) becomes smaller than the relative movement between the first member 21 and the substrate P (the object). For example, the second member 22 may move in synchronization with the substrate P (the object).

The relative movement includes at least one of a relative speed and a relative acceleration. For example, the second member 22 may move so that the relative speed between the second member 22 and the substrate P (the object) is decreased in a state in which the liquid immersion space LS is formed, i.e., a state in which the liquid LQ is present in the second space SP2.

In addition, the second member 22 may move so that the relative acceleration between the second member 22 and the substrate P (the object) is decreased in a state in which the liquid immersion space LS is formed, i.e., a state in which the liquid LQ is present in the second space SP2.

In addition, the second member 22 may move so that the relative speed between the second member 22 and the substrate P (the object) becomes smaller than the relative speed between the first member 21 and the substrate P (the object) in a state in which the liquid immersion space LS is formed, i.e., in a state in which the liquid LQ is present in the second space SP2.

In addition, the second member 22 may move so that the relative acceleration between the second member 22 and the substrate P (the object) becomes smaller than the relative acceleration between the first member 21 and the substrate P (the object) in a state in which the liquid immersion space LS is formed, i.e., in a state in which the liquid LQ is present in the second space SP2.

For example, the second member 22 is movable in the movement direction of the substrate P (the object). For example, when the substrate P (the object) moves in the +X axis direction (or the -X axis direction), the second member 22 is movable in the +X axis direction (or the -X axis direction). In addition, when the substrate P (the object) moves in the +Y axis direction (or the -Y axis direction) while moving in the +X axis direction, the second member 22 is movable in the +X axis direction. In addition, when the substrate P (the object) moves in the +Y axis direction (or the -Y axis direction) while moving in the -X axis direction, the second member 22 is movable in the -X axis direction.

That is, in the embodiment, when the substrate P (the object) moves in the direction which includes a component in the X axis direction, the second member 22 moves in the X axis direction. For example, the second member 22 may move in the X axis direction in parallel with at least a portion of the movement of the substrate P (the object) in the direction including the component in the X axis direction.

Further, the second member 22 may be movable in the Y axis direction. When the substrate P (the object) moves in the direction including the component in the Y axis direction, the second member 22 may move in the Y axis direction. For example, the second member 22 may move in the Y axis direction so that the difference in relative speed between the second member 22 and the substrate P (the object) is decreased in parallel with at least a portion of the movement of the substrate P (the object) in the direction including the component in the Y axis direction.

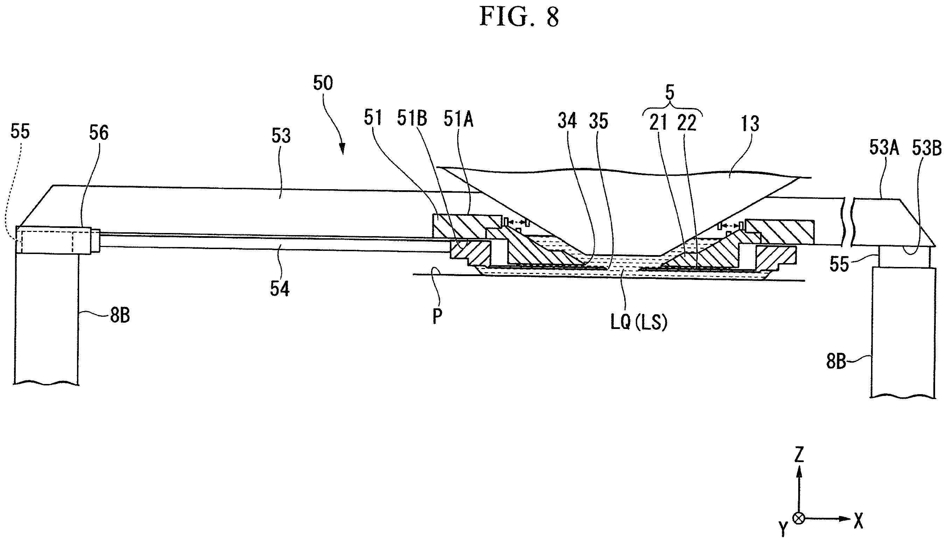

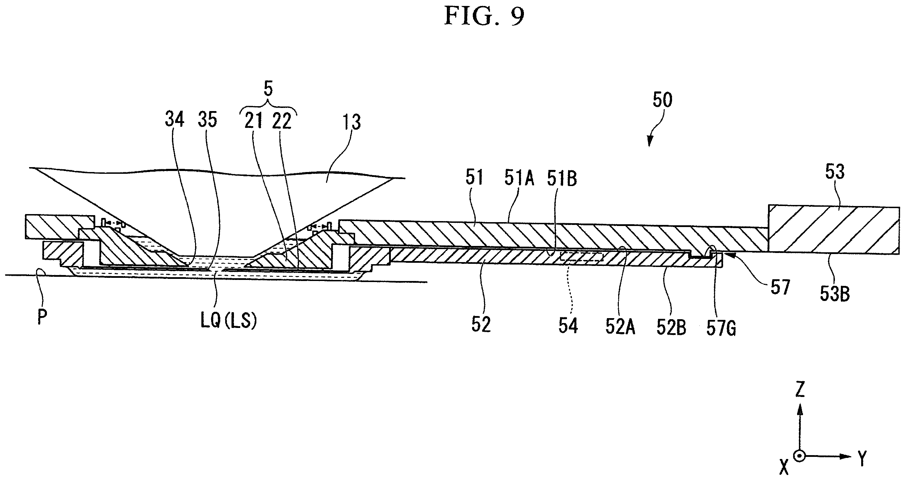

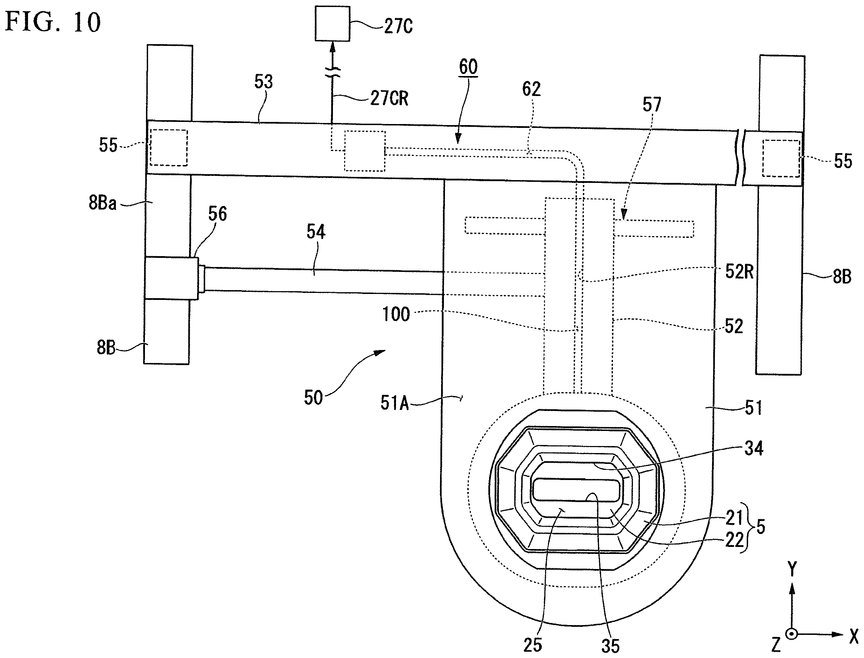

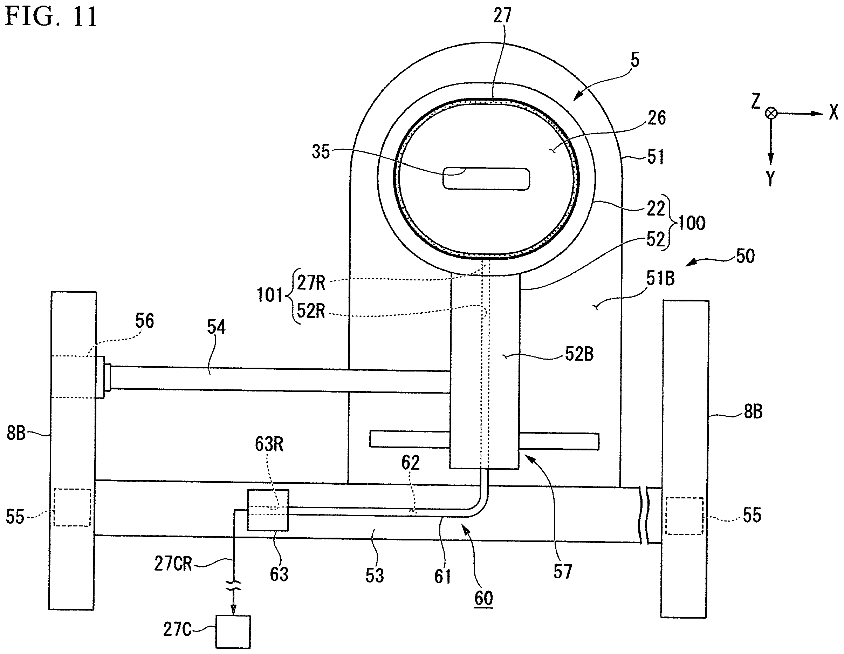

Next, an example of a support apparatus 50 which supports the liquid immersion member 5 will be described. Figs. 8 and 9 are side views showing examples of the liquid immersion member 5 and the support apparatus 50 according to the embodiment. Figs. 10 and 11 are plan views showing the examples of the liquid immersion member 5 and the support apparatus 50 according to the embodiment. Fig. 8 is a view when seen from the -Y side. Fig. 9 is a view when seen from the +X side. Fig. 10 is a view when seen from the +Z side. Fig. 11 is a view when seen from the - Z side.

In the embodiment, the support apparatus 50 has a first support member 51 which supports the first member 21, a second support member 52 which supports the second member 22, a support frame 53 which supports the first support member 51, and a movement frame 54 which supports the second support member 52.

The first support member 51 is connected to the first member 21. The first member 21 is fixed to the first support member 51. The first support member 51 is disposed to surround the first member 21.

The support frame 53 is connected to the first support member 51. The first support member 51 is fixed to the support frame 53. The support frame 53 supports the first member 21 via the first support member 51.

The second support member 52 is connected to the second member 22. The second member 22 is fixed to the second support member 52. In the embodiment, the second support member 52 is connected to a portion of the second member 22 at the +Y side with respect to a center of the opening 35. The second support member 52 is connected to the second member 22 outside the first member 21 with respect to the optical path K. The second support member 52 has an upper surface 52A which faces in the +Z axis direction, and a lower surface 52B which faces in the -Z axis direction.

The movememt frame 54 is connected to the second support member 52. The second support member 52 is fixed to the movememt frame 54. The movememt frame 54 supports the second member 22 via the second support member 52.

In the embodiment, the first member 21 and the second member 22 do not come in contact with each other. The first support member 51 and the second support member 52 do not come in contact with each other. A lower surface 51B of the first support member 51 and the upper surface 52A of the second support member 52 are opposite to each other via a gap.

The support apparatus 50 has a vibration isolator 55 which suppresses vibrations of the first member 21. For example, the vibration isolator 55 suppresses vibrations of the first member 21 caused by the movement of the second member 22. The vibration isolator 55 is controlled by the controller 6. At least a portion of the vibration isolator 55 is disposed between the support frame 53 and the apparatus frame 8B.

The support apparatus 50 has a driving apparatus 56 which moves the second member 22. The second member 22 is moved by the driving apparatus 56. The driving apparatus 56 includes, for example, a motor, and is able to move the second member 22 using the Lorentz force. The driving apparatus 56 is able to move the second member 22 with respect to the first member 21. The driving apparatus 56 is controlled by the controller 6. At least a portion of the driving apparatus 56 is supported by the apparatus frame 8B.

The movememt frame 54 supports the second member 22 via the second support member 52. In the embodiment, the driving apparatus 56 moves the movememt frame 54. As the movememt frame 54 is moved by the driving apparatus 56, the second support member 52 moves. As the second support member 52 is moved by the driving apparatus 56, the second member 22 moves. The second member 22 and the second support member 52 move together.

The support frame 53 is supported by the apparatus frame 8B. The support frame 53 is supported by the apparatus frame 8B via the vibration isolator 55. The vibration isolator 55 supports the first member 21 via the support frame 53 and the first support member 51. The first member 21 is supported by the vibration isolator 55 via the first support member 51 and the support frame 53. The apparatus frame 8B supports the first member 21 via the vibration isolator 55, the support frame 53 and the first support member 51.

The movememt frame 54 is supported by the apparatus frame 8B. The movememt frame 54 is supported by the apparatus frame 8B via the driving apparatus 56. The driving apparatus 56 supports the second member 22 via the movememt frame 54 and the second support member 52. The second member 22 is supported by the driving apparatus 56 via the second support member 52 and the movememt frame 54. The apparatus frame 8B supports the second member 22 via the driving apparatus 56, the movememt frame 54 and the second support member 52.

In the embodiment, the apparatus frame 8B supports the reference frame 8A which supports the projection optical system PL (the terminal optical element 13), the support frame 53 (the vibration isolator 55) which supports the first member 21, and the movememt frame 54 (the driving apparatus 56) which supports the second member 22.

In the embodiment, the driving apparatus 56 is disposed at the -X side with respect to the optical axis of the terminal optical element 13. In the embodiment, the movememt frame 54 is a rod member elongated in the X axis direction.

In the embodiment, the driving apparatus 56 is connected to an end of the -X side of the movememt frame 54. The second support member 52 is connected to an end of the +X side of the movememt frame 54.

The support apparatus 50 has a guide apparatus 57 which guides the second member 22. In the embodiment, the guide apparatus 57 guides the second member 22 in the X axis direction. In the embodiment, at least a portion of the guide apparatus 57 is disposed between the first support member 51 (the first member 21) and the second support member 52 (the second member 22).

The second member 22 is guided in the X axis direction by the guide apparatus 57. In the embodiment, movements of the second member 22 in the Y axis, Z axis, θX, θY, and θZ axis directions are limited. The guide apparatus 57 has a gas bearing 57G disposed between the lower surface 51B of the first support member 51 and the upper surface 52A of the second support member 52. The guide apparatus 57 includes a so-called air guide mechanism. The second support member 22 (the second member 22) is supported by the gas bearing 57G without contacting the first support member 21 (the first member 21). The second support member 22 (the second member 22) is guided in the X axis direction by the gas bearing 57G in a noncontact state with respect to the first support member 21 (the first member 21).

In the embodiment, the second support member 52 has a recovery channel (space) 52R through which the liquid LQ from the recovery channel 27R is able to flow. The recovery channel 52R is formed inside the second support member 52. The recovery channel 52R is connected to the recovery channel 27R. At least a portion of the liquid LQ recovered from the fluid recovery part 27 and flowing into the recovery channel 27R flows into the recovery channel 52R.

In the description below, the second member 22 and the second support member 52 which are movable with respect to the terminal optical element 13 are combined and appropriately referred to as a movable member 100. In addition, the recovery channel 27R and the recovery channel 52R into which the liquid LQ recovered from the fluid recovery part 27 flows are combined and appropriately referred to as a first channel 101.

In the embodiment, the exposure apparatus EX includes a piping system 60 having a channel through which the liquid LQ recovered from the fluid recovery part 27 flows. At least a portion of the piping system 60 is disposed between the movable member 100 and the fluid recovery apparatus 27C. In the embodiment, at least a portion of the piping system 60 is supported by the support frame 53.

The piping system 60 has a second channel 62 connected to the movable member 100 and through which the liquid LQ from the first channel 101 is able to flow, and a deformation member 61, at least a portion of which is deformable. The second channel 62 is formed inside the deformation member 61.

The deformation member 61 is connected to the second support member 52. The deformation member 61 is connected to the second member 22 via the second support member 52.

The first channel 101 is connected to the second channel 62. At least a portion of the liquid LQ in the first channel 101 flows into the second channel 62. The liquid LQ from the first channel 101 is able to flow through the second channel 62.

In the embodiment, the deformation member 61 includes a tube member, at least a portion of which is deformable. In the description below, the deformation member 61 is appropriately referred to as a tube member 61.

The piping system 60 has a relay member 63. In the embodiment, the relay member 63 has a recovery channel (space) 63R through which the liquid LQ from the second channel 62 is able to flow. The recovery channel 63R is formed inside the relay member 63. The recovery channel 63R is connected to the second channel 62. At least a portion of the liquid LQ flowing into the second channel 62 from the first channel 101 flows into the recovery channel 63R.

In the embodiment, the relay member 63 is supported by the support frame 53. The relay member 63 is fixed to the support frame 53. A position of the relay member 63 is fixed.

One end of the tube member 61 is connected to the movable member 100 (the second support member 52). The other end of the tube member 61 is connected to the relay member 63. One end of the second channel 62 is connected to the first channel 101 (the recovery channel 52R). The other end of the second channel 62 is connected to the recovery channel 63R.

The recovery channel 63R and the fluid recovery apparatus 27C are connected via a channel 27CR. The liquid LQ from the fluid recovery part 27 flows into the fluid recovery apparatus 27C via the first channel 101 (the recovery channel 27R and the recovery channel 52R), the second channel 62, the recovery channel 63R, and the channel 27CR. The liquid recovery apparatus 27C is able to recover the liquid LQ recovered from the fluid recovery part 27 via the first channel 101, the second channel 62, the recovery channel 63R, and the channel 27CR.

The tube member 61 is opposite to at least a portion of the support frame 53. The tube member 61 is opposite the support frame 53 via a gap. The tube member 61 is supported by the relay member 63 and the movable member 100 so as not to come in contact with the support frame 53.

Further, the tube member (a deformation member) 61 may come in contact with at least a portion of the support frame 53. At least a portion of the tube member 61 may be supported by the support frame 53.

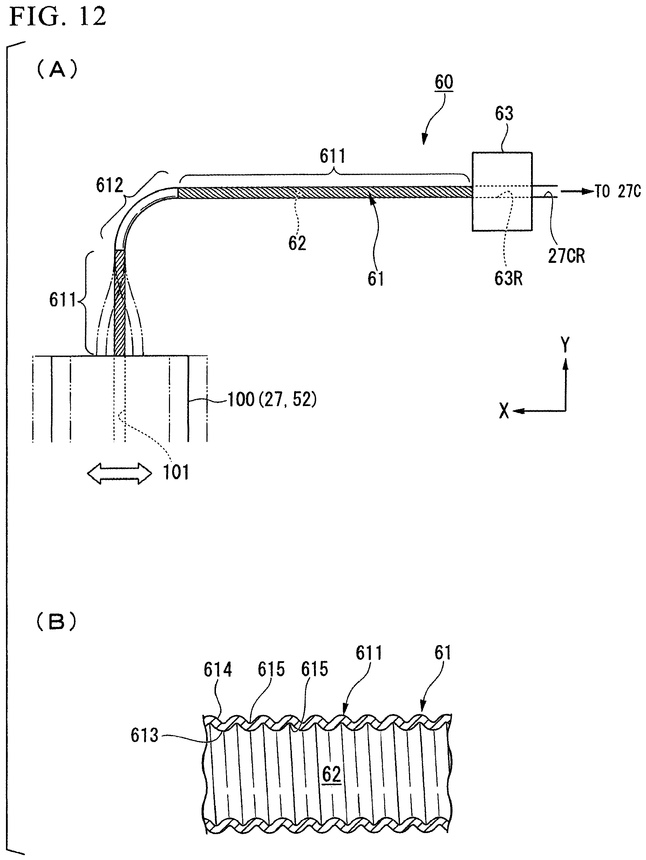

Fig. 12(A) is a view showing an example of the piping system 60, and Fig. 12(B) is a cross-sectional view showing a portion of the tube member 61.

The tube member 61 has a flexible part 611, which is deformable in at least a portion thereof. That is, at least a portion of the tube member 61 has softness. At least a portion of the tube member 61 may have flexibility. At least a portion of the tube member 61 may be elastically deformable.

As shown in Fig. 12(A), the movable member 100 moves in the X axis direction. The tube member 61 is deformable in the movement direction (the X axis direction) of the movable member 100.

The tube member 61 is elastically deformable. In a movable range (a moving range) in which at least the movable member 100 is moved, the tube member 61 is elastically deformable.

The flexible part 611 includes a groove 615 formed at one or both of an inner surface 613 of the tube member 61 which faces the second channel 62, and an outer surface 614 opposite the inner surface 613. As shown in Fig. 12(B), in the embodiment, the grooves 615 are formed at both of the inner surface 613 and the outer surface 614. Further, the groove 615 may be formed at the inner surface 613 but may not be formed at the outer surface 614. Further, the groove 615 may be formed at the outer surface 614 but may not be formed at the inner surface 613.

For example, the groove 615 may be formed at a spiral shape to wind around an axis of the tube member 61. The tube member 61 (the flexible part 611) is deformable by the groove 615.

The flexible part 611 may be formed of a synthetic resin. The flexible part 611 may be formed of a synthetic resin including, for example, fluorine. For example, the flexible part 611 may include a tetra fluoro ethylene-perfluoro alkylvinyl ether copolymer (PFA). For example, the flexible part 611 may include poly tetra fluoroethylene (PTFE).

In the embodiment, the tube member 61 has a curved section 612. The curved section 612 may have or may not have flexibility. In the embodiment, the curved section 612 is not as flexible as the flexible part 611. The curved section 612 is more difficult to be deformed than the flexible part 611.

The curved section 612 is harder than the flexible part 611.

In the embodiment, the groove 615 is formed at at least a portion of the tube member formed of a synthetic resin (for example, PFA). A portion in which the groove 615 is formed becomes the flexible part 611. A portion in which the groove 615 is not formed becomes the curved section 612.

In the embodiment, flexible parts 611 are disposed at one side (the movable member 100 side) of the curved section 612 and the other side (the relay member 63 side). The flexible part 611 of the one side (the movable member 100 side) of the curved section 612 is substantially parallel to the Y axis. The flexible part 611 of the other side (the relay member 63 side) of the curved section 612 is substantially parallel to the X axis. In the embodiment, the flexible part 611 may be referred to as a straight section 611.

In the embodiment, since the piping system 60 has the tube member 61, at least a portion of which is deformable, even when the movable member 100 moves, generation of vibrations is suppressed. That is, the vibrations generated by movement of the movable member 100 are reduced (attenuated) by the tube member 61, which is deformable. In addition, the vibrations generated by movement of the movable member 100 are suppressed from being transmitted to the relay member 63 and the support frame 53 by the tube member 61, which is deformable. Accordingly, even when the movable member 100 is moved, for example, the support frame 53 is suppressed from being vibrated.

Further, in the embodiment, the curved section 612 may have flexibility.

Next, a method of exposing the substrate P using the exposure apparatus EX having the above-mentioned configuration will be described.

At a substrate exchange position separated from the liquid immersion member 5, a process of loading (load) the substrate P before exposure onto the substrate stage 2 (the first holding part) is performed. In at least a portion of a period in which the substrate stage 2 is separated from the liquid immersion member 5, the measurement stage 3 is disposed opposite the terminal optical element 13 and the liquid immersion member 5. The controller 6 performs supply of the liquid LQ from the liquid supply part 31 and recovery of the liquid LQ from the fluid recovery part 27 to form the liquid immersion space LS on the measurement stage 3.

After the substrate P before exposure is loaded onto the substrate stage 2 and measurement processing using the measurement stage 3 is terminated, the controller 6 moves the substrate stage 2 such that the terminal optical element 13 and the liquid immersion member 5 are opposite to the substrate stage 2 (the substrate P). In a state in which the terminal optical element 13 and the liquid immersion member 5 are opposite to the substrate stage 2 (the substrate P), as the recovery of the liquid LQ from the fluid recovery part 27 is performed in parallel with the supply of the liquid LQ from the liquid supply part 31, the liquid immersion space LS is formed between the terminal optical element 13 and the liquid immersion member 5, and the substrate stage 2 (the substrate P) such that the optical path K is filled with the liquid LQ.

In the embodiment, the recovery of the liquid LQ from the fluid recovery part 24 is performed in parallel with the supply of the liquid LQ from the liquid supply part 31 and the recovery of the liquid LQ from the fluid recovery part 27.

The controller 6 starts exposure processing of the substrate P. The controller 6 emits the exposure light EL from the illumination system IL in a state in which the liquid immersion space LS is formed on the substrate P. The illumination system IL illuminates the mask M with the exposure light EL. The exposure light EL from the mask M is radiated to the substrate P via the liquid LQ in the liquid immersion space LS between the projection optical system PL and the emitting surface 12, and the substrate P. Accordingly, the substrate P is exposed to the exposure light EL emitted from the emitting surface 12 via the liquid LQ in the liquid immersion space LS between the emitting surface 12 of the terminal optical element 13 and the substrate P, and an image of the pattern of the mask M is projected to the substrate P.

The exposure apparatus EX of the embodiment is a scanning type exposure apparatus (a so-called scanning stepper) which projects the image of the pattern of the mask M to the substrate P while synchronously moving the mask M and the substrate P in a predetermined scanning direction. In the embodiment, a scanning direction (a synchronous movement direction) of the substrate P is set to the Y axis direction, and a scanning direction (a synchronous movement direction) of the mask M is also set to the Y axis direction. The controller 6 moves the substrate P in the Y axis direction with respect to the projection region PR of the projection optical system PL, and radiates the exposure light EL to the substrate P via the liquid LQ in the liquid immersion space LS on the projection optical system PL and the substrate P while moving the mask M in the Y axis direction with respect to the illumination region IR of the illumination system IL in synchronization with the movement of the substrate P in the Y axis direction.

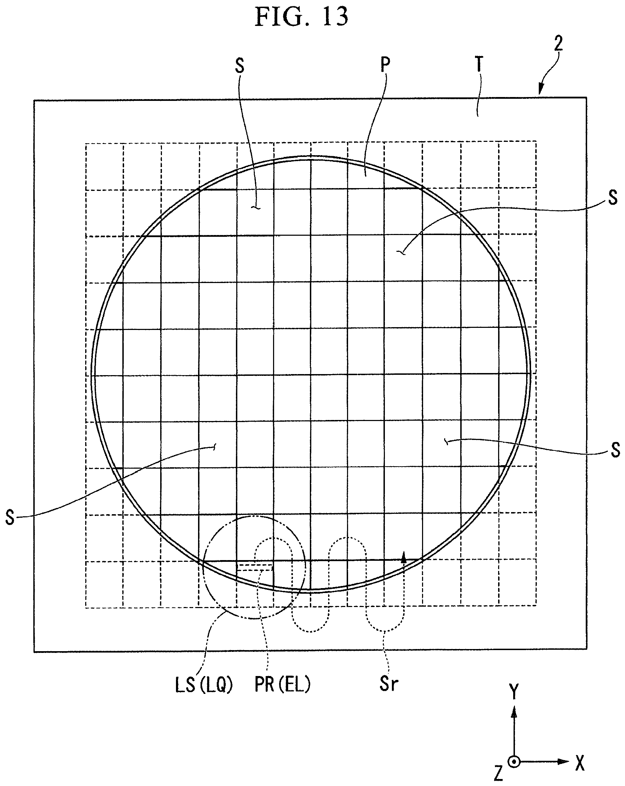

Fig. 13 is a view showing an example of the substrate P held by the substrate stage 2. In the embodiment, a plurality of shot regions S serving as exposure target regions are disposed on the substrate P in a matrix form.

The controller 6 sequentially exposes the plurality of shot regions S of the substrate P to the exposure light EL emitted from the emitting surface 12 via the liquid LQ in the liquid immersion space LS between the emitting surface 12 and the substrate P while moving the substrate P held by the first holding part in the Y axis direction (the scanning direction) with respect to the exposure light EL emitted from the emitting surface 12 of the terminal optical element 13.

For example, in order to expose one shot region S of the substrate P, the controller 6 moves the substrate P in the Y axis direction with respect to the exposure light EL (the projection region PR of the projection optical system PL) emitted from the emitting surface 12 in a state in which the liquid immersion space LS is formed, and radiates the exposure light EL to the shot region S via the liquid LQ in the liquid immersion space LS on the projection optical system PL and the substrate P while moving the mask M in the Y axis direction with respect to the illumination region IR of the illumination system IL in synchronization with the movement of the substrate P in the Y axis direction. Accordingly, the image of the pattern of the mask M is projected to the shot region S, and the shot region S is exposed to the exposure light EL emitted from the emitting surface 12.

After the exposure of the shot region S is terminated, the controller 6 moves the substrate P in a direction crossing the Y axis in the XY plane (for example, the X axis direction, a direction inclined with respect to the X axis and Y axis directions in the XY plane, or the like) in a state in which the liquid immersion space LS is formed, and moves the next shot region S to the exposure starting position in order to start the exposure of the next shot region S. After that, the controller 6 starts the exposure of the shot region S.

The controller 6 sequentially exposes the plurality of shot regions of the substrate P while repeating an operation of exposing the shot region while moving the shot region in the Y axis direction with respect to a position (the projection region PR) to which the exposure light EL from the emitting surface 12 is radiated in a state in which the liquid immersion space LS is formed on the substrate P (the substrate stage 2), and an operation of moving the substrate P in a direction crossing the Y axis direction in the XY plane (for example, the X axis direction, a direction inclined with respect to the X axis and Y axis directions in the XY plane, or the like) such that the next shot region is disposed at the exposure starting position in a state in which the liquid immersion space LS is formed on the substrate P (the substrate stage 2) after exposure of the shot region.

In the description below, the operation, which moves the substrate P (the shot region) in the Y axis direction with respect to the position (the projection region PR) irradiated with the exposure light EL from the emitting surface 12 in the state in which the liquid immersion space LS is formed above the substrate P (the substrate stage 2) in order to expose the shot region, is appropriately referred to as a scan movement operation. Moreover, the operation, which moves the substrate P in the XY plane before the exposure of the next shot region starts in the state in which the liquid immersion space LS is formed on the substrate P (the substrate stage 2) after the exposure of a predetermined shot region is terminated, is appropriately referred to as a step movement operation.

In the embodiment, the scan movement operation includes an operation in which the substrate P moves in the Y axis direction from a state in which a predetermined shot region S is disposed at the exposure starting position to a state in which the predetermined shot region is disposed at the exposure termination position. The step movement operation includes an operation in which the substrate P moves in a direction crossing the Y axis direction in the XY plane from a state in which a predetermined shot region S is disposed at the exposure termination position to a state in which the next shot region S is disposed at the exposure starting position.

The exposure starting position includes a position of the substrate P when one end in the Y axis direction of a predetermined shot region S passes through the projection region PR in order to expose the shot region S. The exposure termination position includes a position of the substrate P when the other end in the Y axis direction of the shot region S irradiated with the exposure light EL passes through the projection region PR.

The exposure starting position of the shot region S includes a starting position of the scan movement operation in order to expose the shot region S. The exposure starting position of the shot region S includes a termination position of the step movement operation in order to dispose the shot region S at the exposure starting position.

The exposure termination position of the shot region S includes a termination position of the scan movement operation in order to expose the shot region S. The exposure termination position of the shot region S includes a starting position of the step movement operation in order to dispose the next shot region S at the exposure starting position after the exposure of the shot region S is terminated.

In the descriptions below, a period, in which the scan movement operation is performed in order to expose a predetermined shot region S, is appropriately referred to as a scan movement period. In the descriptions below, a period, in which the step movement operation is performed in order to start the exposure of the next shot region S after the exposure termination of a predetermined shot region S, is appropriately referred to as a step movement period.

The scan movement period includes the exposure period from the exposure start of a predetermined shot region S to the exposure termination. The step movement period includes a movement period of the substrate P from the exposure termination of a predetermined shot region S to the exposure start of the next shot region S.

In the scan movement operation, the exposure light EL is emitted from the emitting surface 12. In the scan movement operation, the exposure light EL is radiated to the substrate P (the object). In the step movement operation, the exposure light EL is not emitted from the emitting surface 12. In the step movement operation, the exposure light EL is not radiated to the substrate P (the object).

The controller 6 sequentially exposes the plurality of shot regions S of the substrate P while repeating the scan movement operation and the step movement operation. Further, the scan movement operation is a constant speed movement mainly in the Y axis direction. The step movement operation includes acceleration and deceleration movements. For example, the step movement operation from the exposure termination of a predetermined shot region S to the exposure start of the next shot region S includes one or both of the acceleration and deceleration movement in the Y axis direction and the acceleration and deceleration movement in the X axis direction.

Moreover, there is a case where at least a portion of the liquid immersion space LS may be formed above the substrate stage 2 (the cover member T) in at least a portion of the scan movement operation and the step movement operation. There is a case where the liquid immersion space LS may be formed over the substrate P and the substrate stage 2 (the cover member T) in at least a portion of the scan movement operation and the step movement operation. When the exposure of the substrate P is performed in a state in which the substrate stage 2 and the measurement stage 3 approach or contact each other, there is a case where the liquid immersion space LS may be formed over the substrate stage 2 (the cover member T) and the measurement stage 3 in at least a portion of the scan movement operation and the step movement operation.

The controller 6 controls the driving system 15 based on exposure conditions of the plurality of shot regions S on the substrate P and moves the substrate P (substrate stage 2). For example, the exposure conditions of the plurality of shot regions S are defined by exposure control information referred to as an exposure recipe. The exposure control information is stored in the storage device 7.

The exposure conditions (exposure control information) include arrangement information (the position of each of the plurality of shot regions S in the substrate P) of the plurality of shot region S. Moreover, the exposure conditions (exposure control information) include size information (size information with respect to the Y axis direction) of each of the plurality of shot regions S.

The controller 6 sequentially exposes the plurality of shot regions S while moving the substrate P according to a predetermined movement condition based on the exposure conditions (exposure control information) stored in the storage device 7. The movement conditions of the substrate P (the object) include at least one of the movement speed, the acceleration, the movement distance, the movement direction, and the movement trajectory in the XY plane.

As an example, when the plurality of shot regions S are sequentially exposed, the controller 6 radiates the exposure light EL to the projection region PR while moving the substrate stage 2 so that the projection region PR of the projection optical system PL and the substrate P are relatively moved along the movement trajectory shown by an arrow Sr in FIG 13, and sequentially exposes the plurality of shot regions S via the liquid LQ to the exposure light EL. The controller 6 sequentially exposes the plurality of shot regions S while repeating the scan movement operation and the step movement operation.

In the embodiment, the second member 22 moves in at least a portion of the exposure processing of the substrate P. The second member 22 moves in parallel with at least a portion of the step movement operation of the substrate P (the substrate stage 2) in the state in which the liquid immersion space LS is formed. For example, the second member 22 moves in parallel with at least a portion of the scan movement operation of the substrate P (the substrate stage 2) in the state in which the liquid immersion space LS is formed. The exposure light EL is emitted from the emitting surface 12 in parallel with the movement of the second member 22. Further, the second member 22 may not move during the scan movement operation. That is, the second member 22 may not move in parallel with the emission of the exposure light EL from the emitting surface 12. For example, the second member 22 may move so that the relative movement (the relative speed, the relative acceleration) between the second member 22 and the substrate P (the substrate stage 2) is decreased when the substrate P (the substrate stage 2) performs the step movement operation. In addition, the second member 22 may move so that the relative movement (the relative speed, the relative acceleration) between the second member 22 and the substrate P (the substrate stage 2) is decreased when the substrate P (the substrate stage 2) performs the scan movement operation.

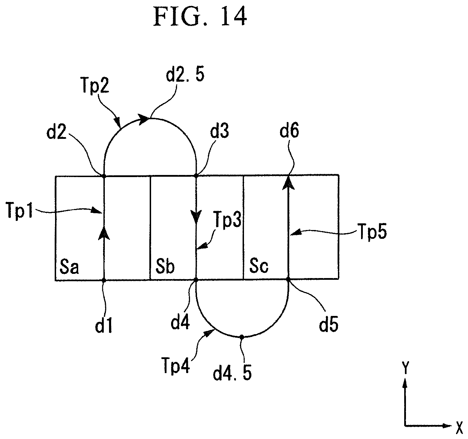

Fig. 14 is a view schematically showing an example of the movement trajectory of the substrate P when sequentially exposing a shot region Sa, a shot region Sb, and a shot region Sc while performing the step movement which includes the components in the +X axis direction on the substrate P. The shot regions Sa, Sb, and Sc are disposed in the X axis direction.

As shown in Fig. 14, when the shot regions Sa, Sb and Sc are exposed, the substrate P sequentially moves along a pathway Tp1 from a position d1 to a position d2 adjacent to the +Y side with respect to the position d1, a pathway Tp2 from the position d2 to a position d3 adjacent to the +X side with respect to the position d2, a pathway Tp3 from the position d3 to a position d4 adjacent to the -Y side with respect to the position d3, a pathway Tp4 from the position d4 to a position d5 adjacent to the +X side with respect to the position d4, and a pathway Tp5 from the position d5 to a position d6 adjacent to the +Y side with respect to the position d5, under the terminal optical element 13. The positions d1, d2, d3, d4, d5 and d6 are positions in the XY plane.

At least a portion of the pathway Tp1 is a straight line parallel to the Y axis. At least a portion of the pathway Tp3 is a straight line parallel to the Y axis. At least a portion of the pathway Tp5 includes a straight line parallel to the Y axis. The pathway Tp2 includes a curved line passing through a position d2.5. The pathway Tp4 includes a curved line passing through a position d4.5. The position d1 includes the start point of the pathway Tp1, and the position d2 includes the end point of the pathway Tp1. The position d2 includes the start point of the pathway Tp2, and the position d3 includes the end point of the pathway Tp2. The position d3 includes the start point of the pathway Tp3, and the position d4 includes the end point of the pathway Tp3. The position d4 includes the start point of the pathway Tp4, and the position d5 includes the end point of the pathway Tp4. The position d5 includes the start point of the pathway Tp5, and the position d6 includes the end point of the pathway Tp5. The pathway Tp1 is a pathway on which the substrate P moves in the +Y axis direction. The pathway Tp3 is a pathway on which the substrate P moves in the -Y axis direction. The pathway Tp5 is a pathway on which the substrate P moves in the +Y axis direction. The pathway Tp2 and the pathway Tp4 are pathways on which the substrate P moves in the direction which has the +X axis direction as the main component.

When the substrate P moves along the pathway Tp1 in the state in which the liquid immersion space LS is formed, the exposure light EL is radiated to the shot region Sa via the liquid LQ. When the substrate P moves along the pathway Tp3 in the state in which the liquid immersion space LS is formed, the exposure light EL is radiated to the shot region Sb via the liquid LQ. When the substrate P moves along the pathway Tp5 in the state in which the liquid immersion space LS is formed, the exposure light EL is radiated to the shot region Sc via the liquid LQ. When the substrate P moves the pathway Tp2 and the pathway Tp4, the exposure light EL is not radiated.

The operation in which the substrate P moves along the pathway Tp1, the operation in which the substrate P moves along the pathway Tp3, and the operation in which the substrate P moves along the pathway Tp5 each include the scan movement operation. Moreover, the operation in which the substrate P moves along the pathway Tp2 and the operation in which the substrate P moves along the pathway Tp4 each include the step movement operation.

That is, the period in which the substrate P moves along the pathway Tp1, the period in which the substrate P moves along the pathway Tp3, and the period in which the substrate P moves along the pathway Tp5 each include the scan movement period (the exposure period). The period in which the substrate P moves along the pathway Tp2 and the period in which the substrate P moves along the pathway Tp4 each include the step movement period.

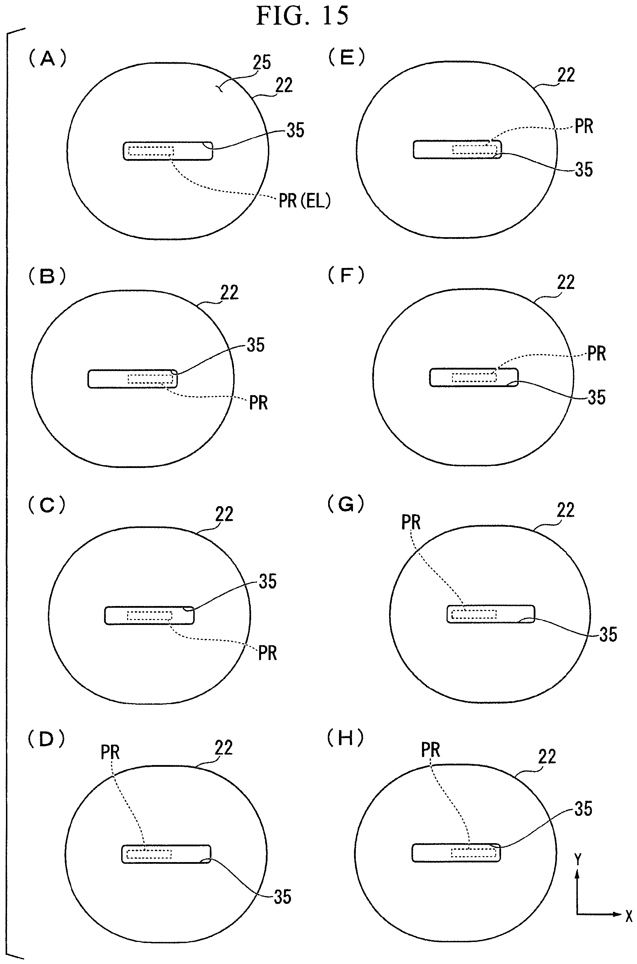

Fig. 15 is a schematic diagram showing an example of the operation of the second member 22. Fig. 15 is a view showing the second member 22 when seen from the upper surface 25 side.

When the substrate P is disposed at the position d1 of Fig. 15, the second member 22 is disposed at a position shown in Fig. 15(A) with respect to the projection region PR (the optical path K of the exposure light EL). When the substrate P is disposed at the position d2, the second member 22 is disposed at a position shown in Fig. 15(B) with respect to the projection region PR (the optical path K of the exposure light EL). That is, during the scan movement operation of the substrate P from the position d1 to the position d2, the second member 22 moves in the -X axis direction reverse to the direction (the +X axis direction) of the step movement of the substrate P.

When the substrate P is disposed at the position d2.5, the second member 22 is disposed at a position shown in Fig. 15(C) with respect to the projection region PR (the optical path K of the exposure light EL). When the substrate P is disposed at the position d3, the second member 22 is disposed at a position shown in Fig. 15(D) with respect to the projection region PR (the optical path K of the exposure light EL). That is, during the step movement operation of the substrate P from the position d2 to the position d3, the second member 22 moves in the +X axis direction which is the same as the direction (the +X axis direction) of the step movement of the substrate P.

When the substrate P is disposed at the position d4, the second member 22 is disposed at a position shown in Fig. 15(E) with respect to the projection region PR (the optical path K of the exposure light EL). That is, during the scan movement operation of the substrate P from the position d3 to the position d4, the second member 22 moves in the -X axis direction reverse to the direction (the +X axis direction) of the step movement of the substrate P.

When the substrate P is disposed at the position d4.5, the second member 22 is disposed at a position shown in Fig. 15(F) with respect to the projection region PR (the optical path K of the exposure light EL). When the substrate P is disposed at the position d5, the second member 22 is disposed at a position shown in Fig. 15(G) with respect to the projection region PR (the optical path K of the exposure light EL). That is, during the step movement operation of the substrate P from the position d4 to the position d5, the second member 22 moves in the +X axis direction which is the same direction (the +X axis direction) of the step movement of the substrate P.

When the substrate P is disposed at the position d6, the second member 22 is disposed at a position shown in Fig. 15(H) with respect to the projection region PR (the optical path K of the exposure light EL). That is, during the scan operation movement of the substrate P from the position d5 to the position d6, the second member 22 moves in the -X axis direction reverse to the direction (the +X axis direction) of the step movement of the substrate P.

In the embodiment, the position of the second member 22 shown in Figs. 15(A), 15(D) and 15(G) is a position (a second end position) of the farthest end of the +X side in the movable range (the moving range) of the second member 22 defined in the X axis direction. The position of the second member 22 shown in Figs. 15(B), 15(E) and 15(H) is a position (a first end position) of the farthest end of the -X side in the movable range (the moving range) of the second member 22 defined in the X axis direction. The position of the second member 22 shown in Figs. 15(C) and 15(F) is a position in the center (a center position) in the movable range (the moving range) of the second member 22 defined in the X axis direction.

When the substrate P moves along the pathway Tp1, the second member 22 moves in the -X axis direction to be changed from a state shown in Fig. 15(A) to a state shown in Fig. 15(B). That is, the second member 22 moves from the second end position to the first end position via the center position. When the substrate P moves along the pathway Tp2, the second member 22 moves in the +X axis direction to be changed from a state shown in Fig. 15(B) to a state shown in Fig. 15(D) via a state shown in Fig. 15(C). That is, the second member 22 moves from the first end position to the second end position via the center position. When the substrate P moves along the pathway Tp3, the second member 22 moves in the -X axis direction to be changed from a state show in Fig. 15(D) to a state shown in Fig. 15(E). That is, the second member 22 moves from the second end position to the first end position via the center position. When the substrate P moves along the pathway Tp4, the second member 22 moves in the +X axis direction from a state shown in Fig. 15(E) to a state shown in Fig. 15(G) via a state shown in Fig. 15(F). That is, the second member 22 moves the first end position to the second end position via the center position. When the substrate P moves along the pathway Tp5, the second member 22 moves in the -X axis direction to be changed from a state shown in Fig. 15(G) to a state shown in Fig. 15(H). That is, the second member 22 moves from the second end position to the first end position via the center position.

That is, in the embodiment, in at least a part of the period in which the substrate P moves along the pathway Tp2, the second member 22 moves in the +X axis direction so that the relative movement between the second member 22 and the substrate P is decreased. In other words, in at least a part of the period of the step movement operation of the substrate P which includes the component in the +X axis direction, the second member 22 moves in the +X axis direction so that the relative speed between the second member 22 and the substrate P in the X axis direction is decreased. Similarly, in at least a part of the period in which the substrate P moves along the pathway Tp4, the second member 22 moves in the +X axis direction so that the relative speed between the second member 22 and the substrate P in the X axis direction is decreased.

In addition, in the embodiment, in at least a part of the period in which the substrate P moves along the pathway Tp3, the second member 22 moves in the -X axis direction. Accordingly, after movement of the substrate P along the pathway Tp3, during the movement along the pathway Tp4, even when the second member 22 moves in the +X axis direction, the exposure light EL is able to pass through the opening 35. The case where the substrate P moves along the pathways Tp1 and Tp5 is also similar to the above-mentioned case.

That is, when the substrate P repeats the scan movement operation and the step movement operation including the component in the +X axis direction, during the step movement operation, the second member 22 moves in the +X axis direction from the first end position to the second end position so that the relative speed between the second member 22 and the substrate P is decreased, and during the scan movement operation, the second member 22 is returned from the second end position to the first end position so that the second member 22 is able to move in the +X axis direction again in the next step movement operation. That is, in at least a part of the period in which the substrate P performs the scan movement operation, since the second member 22 moves in the -X axis direction, the dimension of the opening 35 is suppressed to the required minimum.

In addition, in the embodiment, even when the second member 22 is disposed at the first end position (the second end position), at least a portion of the fluid recovery part 27 is continuously opposite to the substrate P (the object). Accordingly, for example, in the step movement operation, the fluid recovery part 27 is able to recover the liquid LQ on the substrate P (the object).

Further, in the example described using Figs. 14 and 15, when the substrate P is disposed at the positions d1, d3 and d5, the second member 22 is considered as being disposed at the second end position. When the substrate P is disposed at the positions d1, d3 and d5, the second member 22 may be disposed at the center position or may be disposed between the center position and the second end position.

Further, in the example described using Figs 14 and 15, when the substrate P is disposed at the positions d2, d4 and d6, the second member 22 is considered as being disposed at the first end position. When the substrate P is disposed at the positions d2, d4 and d6, the second member 22 may be disposed at the center position or may be disposed between the center position and the first end position.

In addition, when the substrate P is disposed at the positions d2.5 and d4.5, the second member 22 may be disposed at positions different from the center position. That is, when the substrate P is disposed at the positions d2.5 and d4.5, for example, the second member 22 may be disposed between the center position and the second end position or may be disposed between the center position and the first end position.

As described above, according to the embodiment, since the deformation member 61, at least a portion of which is deformable, is connected to the movable member 100 having the fluid recovery part 27, even when the movable member 100 is moved, occurrence of vibrations is suppressed. In addition, the liquid LQ recovered from the fluid recovery part 27 can be recovered via the first channel 101 and the second channel 62 while suppressing the occurrence of vibrations. Accordingly, occurrence of the exposure failure and occurrence of a defective device are suppressed.

### <Second embodiment>

A second embodiment will be described. In the description below, the same reference numerals are designated to the same or similar components as those of the above-mentioned embodiment, and descriptions thereof will be simplified or omitted.

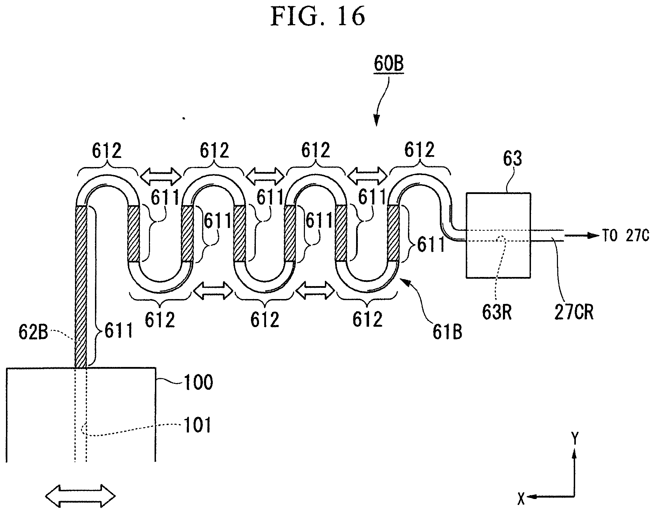

Fig. 16 is a view showing an example of a piping system 60B according to the embodiment. The piping system 60B has a deformation member (a tube member) 61B at least a portion of which is deformable and connected to the movable member 100. The tube member 61B has a second channel 62B through which the liquid LQ from the first channel 101 of the movable member 100 is able to flow.

The tube member 61B has a flexible part 611, which is deformable, and a curved section 612 which is more difficult to be deformed than the flexible part 612. The tube member 61B has a plurality of flexible parts 611. In addition, the tube member 61B has a plurality of curved sections 612. The flexible parts 611 are disposed between the plurality of curved sections 612.

In the embodiment, the tube member 61B has the plurality of curved sections 612 to meander. The plurality of curved sections 612 are disposed in the movement direction (the X axis direction) of the movable member 100. The plurality of flexible parts 611 are disposed to be substantially parallel to the Y axis.

The tube member 61B is deformable in the movement direction (the X axis direction) of the movable member 100. In the moving range in which the movable member 100 moves, the tube member 61B is elastically deformable.

As described above, even in this embodiment, since the piping system 60B has the tube member 61B, at least a portion of which is deformable, even when the movable member 100 moves, occurrence of vibrations is suppressed. For example, even when the movable member 100 moves, the support frame 53 is suppressed from being vibrated. Accordingly, occurrence of exposure failure and generation of a defective device are suppressed.

In the embodiment, the tube member 61B has the plurality of curved sections 612 disposed in the X axis direction and the flexible parts 611 disposed between the plurality of curved sections 612. For this reason, even when the movable member 100 moves, stress concentration in the tube member 61B is suppressed.

Further, in the embodiment, the curved section 612 may have flexibility.

### <Third embodiment>

A third embodiment will be described. In the description below, the same reference numerals are designated to the same or similar components as those of the above-mentioned embodiment, and descriptions thereof will be simplified or omitted.

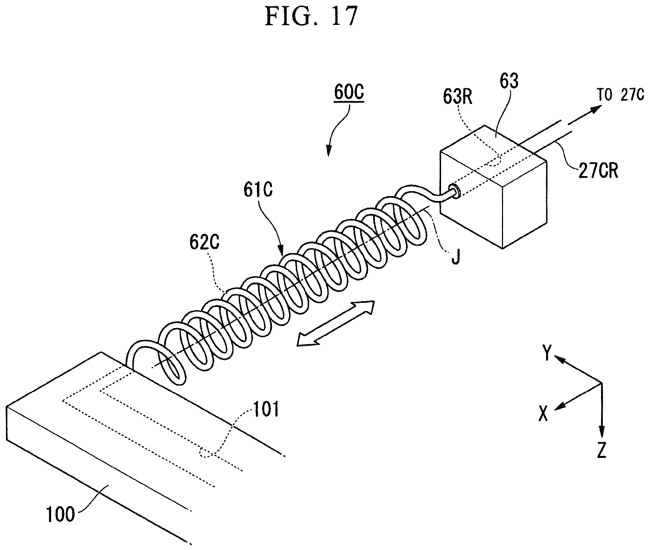

Fig. 17 is a view showing an example of a piping system 60C according to the embodiment. The piping system 60C has a deformation member (a tube member) 61C at least a portion of which is deformable and connected to the movable member 100. The tube member 61C has a second channel 62C through which the liquid LQ from the first channel 101 of the movable member 100 is able to flow.

The tube member 61C has flexibility. The tube member 61C may be formed of a synthetic resin. The tube member 61C may be formed of a synthetic resin including fluorine. For example, tube member 61C may include a tetra fluoro ethylene-perfluoro alkylvinyl ether copolymer (PFA). For example, the tube member 61C may include poly tetra fluoroethylene (PTFE).

The tube member 61C is formed in a spiral shape to wrap around an axis J (an imaginary axis) parallel to the movement direction (the X axis direction) of the movable member 100.

The tube member 61C is deformable in the movement direction (the X axis direction) of the movable member 100. In the moving range in which the movable member 100 moves, the tube member 61C is elastically deformable. In the embodiment, the tube member 61C is elastically deformable like a coil spring.

Even in this embodiment, occurrence of vibrations is suppressed. Accordingly, occurrence of exposure failure and generation of a defective device are suppressed.

### <Fourth embodiment>

A fourth embodiment will be described. In the description below, the same reference numerals are designated to the same or similar components as those of the above-mentioned embodiment, and descriptions thereof will be simplified or omitted.

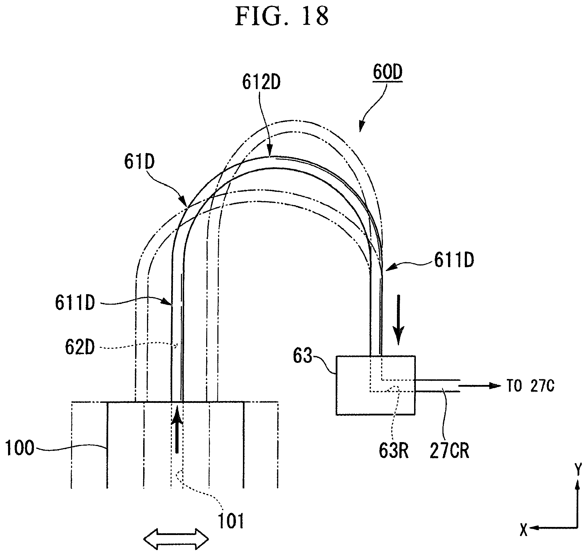

Fig. 18 is a view showing an example of a piping system 60D according to the embodiment The piping system 60D has a deformation member (a tube member) at least a part of which is deformable 61D and connected to the movable member 100. The tube member 61D has a second channel 62D through which the liquid LQ from the first channel 101 of the movable member 100 is able to flow.

An end of the tube member 61D is connected to the movable member 100. The other end of the tube member 61D is connected to the relay member 63. A position of the relay member 63 is fixed.

The movable member 100 moves in the X axis direction. The relay member 63 is disposed in a direction (the X axis direction) parallel to the movement direction of the movable member 100 with respect to the movable member 100. In an example shown in Fig. 18, the relay member 63 is disposed at the -X side with respect to the movable member 100.

The tube member 61D includes a curved section 612D, a straight section 611D disposed at one side (the movable member 100 side) of the curved section 612D and being substantially parallel to the Y axis, and a straight section 611D disposed at the other side (the relay member 63 side) of the curved section 612D and being substantially parallel to the Y axis. The tube member 61D has softness (flexibility). For example, the tube member 61D includes a synthetic resin such as a polyolefin or the like.

As shown in Fig. 18, as the movable member 100 moves in the X axis direction, at least a portion of the tube member 61D is deformed. For example, as the movable member 100 moves in the -X axis direction (moves closer to the relay member 63), the tube member 61D is deformed such that a radius of curvature of the curved section 612D is increased while the straight section 611D of the one side of the curved section 612D and the straight section 611D of the other side approach each other. As the movable member 100 moves in the +X axis direction (moves away from the relay member 63), the tube member 61D is deformed such that a radius of curvature of the curved section 612D is decreased while the straight section 611D of the one side of the curved section 612D and the straight section 611D of the other side move away from each other. In the moving range in which the movable member 100 moves, the tube member 61D is elastically deformable.

Even in this embodiment, occurrence of vibrations is suppressed. Accordingly, occurrence of exposure failure and generation of a defective device are suppressed.

### <Fifth embodiment>

A fifth embodiment will be described. In the description below, the same reference numerals are designated to the same or similar components as those of the above-mentioned embodiment, and descriptions thereof will be simplified or omitted.

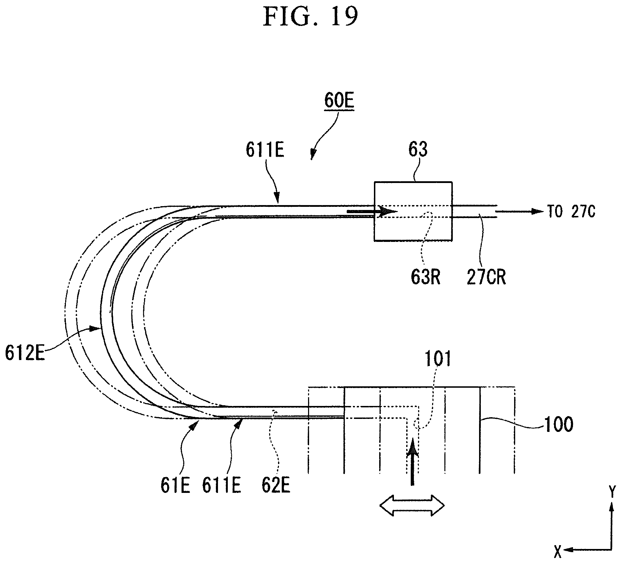

Fig. 19 is a view showing an example of a piping system 60E according to the embodiment. The piping system 60E has a deformation member (a tube member) 61E connected to the movable member 100 and at least a portion of which is deformable. The tube member 61E has a second channel 62E through which the liquid LQ from the first channel 101 of the movable member 100 is able to flow.

One end of the tube member 61E is connected to the movable member 100. The other end of the tube member 61E is connected to the relay member 63. A position of the relay member 63 is fixed.

The movable member 100 moves in the X axis direction. The relay member 63 is disposed in a direction (the Y axis direction) crossing the movement direction of the movable member 100 with respect to the movable member 100. In an example shown in Fig. 19, the relay member 63 is disposed at the +Y side with respect to the movable member 100.

The tube member 61E includes a curved section 612E, a straight section 611E disposed at one side (the movable member 100 side) of the curved section 612E and being substantially parallel to the X axis, and a straight section 611E disposed at the other side (the relay member 63 side) of the curved section 612E and being substantially parallel to the X axis. The tube member 61E has softness (flexibility). For example, the tube member 61E includes a synthetic resin such as a polyolefin or the like.

As shown in Fig. 19, as the movable member 100 moves in the X axis direction, at least a portion of the tube member 61E is deformed. In the embodiment, even when the movable member 100 moves in the X axis direction, a radius of curvature of the curved section 612E is not substantially varied. In the moving range in which the movable member 100 moves, the tube member 61E is elastically deformable.

Even in this embodiment, occurrence of vibrations is suppressed. Accordingly, occurrence of exposure failure and generation of a defective device are suppressed.

### <Sixth embodiment>

A sixth embodiment will be described. In the description below, the same reference numerals are designated to the same or similar components as those of the above-mentioned embodiment, and descriptions thereof will be simplified or omitted.

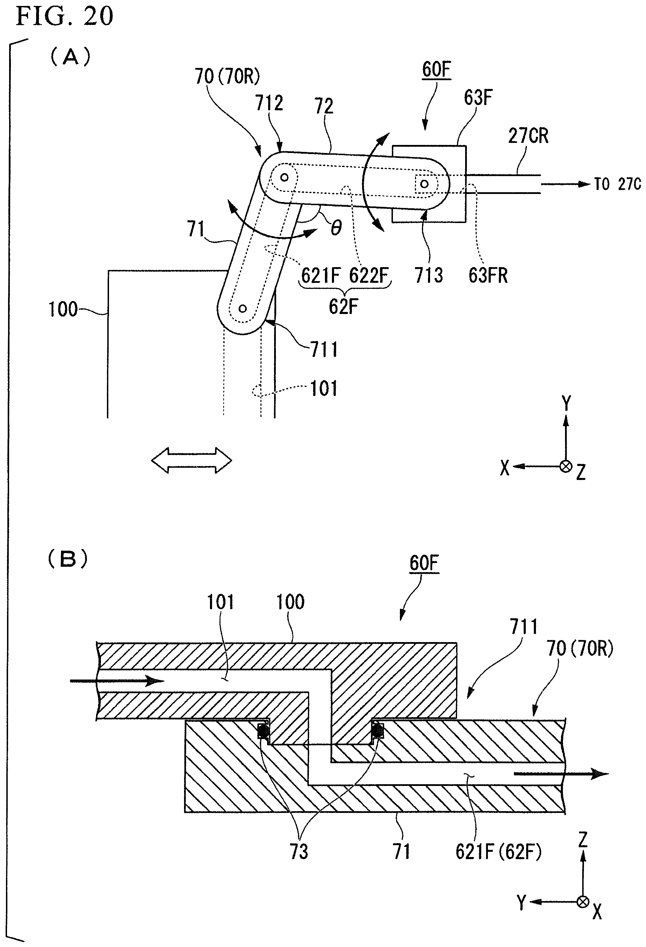

Fig. 20(A) is a view showing an example of a piping system 60F according to the embodiment. Fig. 20(B) is a cross-sectional view showing a portion of the piping system 60F according to the embodiment. The piping system 60F has a second channel 62F, at least a portion of which is opposite to the movable member 100, and through which the liquid LQ from the first channel 101 of the movable member 100 is able to flow, and includes a connection device 70, at least a portion of which is relatively movable with respect to the movable member 100.

In the embodiment, the connection device 70 includes a link mechanism 70R having a first link member 71 and a second link member 72. The first link member 71 is connected to the movable member 100 via a first joint section 711. The second link member 72 is connected to the first link member 71 via a second joint section 712.

The second channel 62F is formed at the first link member 71 and the second link member 72. A portion 621F of the second channel 62F is formed inside the first link member 71. A portion 622F of the second channel 62F is formed inside the second link member 72.

In the description below, the portion 621F of the second channel 62F formed at the first link member 71 is appropriately referred to as a first part 621F. The portion 622F of the second channel 62F formed at the second link member 72 is appropriately referred to as a second part 622F.

The first channel 101 is connected to the second channel 62F (the first part 621F). At least a portion of the liquid LQ recovered from the fluid recovery part 27 and introduced into the first channel 101 flows into the first part 621F of the second channel 62F.

The first part 621F is connected to the second part 622F. At least a portion of the liquid LQ introduced into the first part 621F from the first channel 101 flows into the second part 622F.

The piping system 60F has a relay member 63F. The relay member 63F is connected to the second link member 72 via a third joint section 713. The relay member 63F has a recovery channel 63FR through which the liquid LQ from the second channel 62F (the second part 622F) is able to flow. The recovery channel 63FR is formed inside the relay member 63F.

The second channel 62F (the second part 622F) is connected to the recovery channel 63FR. At least a portion of the liquid LQ introduced into the second channel 62F (the second part 622F) from the first channel 101 flows into the recovery channel 63FR.

The relay member 63F is supported by the support frame 53. The relay member 63F is fixed to the support frame 53. A position of the relay member 63F is fixed. The support frame 53 supports the connection device 70. Further, the relay member 63F may support at least a portion of the connection device 70, and the support frame 53 may support at least a portion of the connection device 70 via the relay member 63F.

The recovery channel 63FR and the liquid recovery apparatus 27C are connected to each other via the channel 27CR. The recovery channel 63FR and the channel 27CR communicate with the liquid recovery apparatus 27C. The first channel 101 is connected to the recovery channel 63FR in communication with the liquid recovery apparatus 27C via the second channel 62F of the connection device 70. The liquid LQ from the fluid recovery part 27 is recovered by the liquid recovery apparatus 27C via the first channel 101, the second channel 62F, the recovery channel 63FR and the channel 27CR.

The connection device 70 relatively moves with respect to the movable member 100 in a state in which at least a portion thereof is opposite to the movable member 100. In the embodiment, the first link member 71 is movable (pivotable, rotatable) in the θZ axis direction with respect to the movable member 100 about the first joint section 711 in a state in which at least a portion of the first link member 71 is opposite to the movable member 100.

In addition, the second link member 72 is movable (pivotable, rotatable) in the θZ axis direction with respect to the first link member 71 about a second joint section 712 in a state in which at least a portion of the second link member 72 is opposite to the first link member 71.

In addition, the second link member 72 is movable (pivotable, rotatable) in the θZ axis direction with respect to the relay member 63F about the third joint section 713 in a state in which at least a portion of the second link member 72 is opposite to the relay member 63F.

Fig. 20(B) is a cross-sectional view of the first joint section 711. As shown in Fig. 20(B), in the first joint section 711, the movable member 100 and the first link member 71 are connected such that the first channel 101 and the second channel 62F (the first part 621F) are connected to each other. At least a portion of the first link member 71 is opposite to the movable member 100 via a gap.

Accordingly, the first link member 71 and the movable member 100 are smoothly and relatively movable to each other. In addition, occurrence of vibrations is suppressed.

The connection device 70 has a seal member 73 which seals a connecting section between the first channel 101 and the second channel 62F (the first part 621F) in the first joint section 711. A leakage of the liquid LQ in the first joint section 711 is suppressed by the seal member 73.

The seal member 73 has lubricity. A coefficient of friction of the seal member 73 is smaller than a coefficient of friction of the movable member 100 and the connection device 70 (the first link member 71). Accordingly, the first link member 71 and the movable member 100 are smoothly movable. In addition, occurrence of vibrations is suppressed.

The seal member 73 has chemical resistance. The seal member 73 is difficult to dissolve in the liquid LQ even when the seal member comes in contact with the liquid LQ. In other words, the seal member 73 is less dissolved with respect to the liquid LQ. Accordingly, contamination of the liquid LQ flowing through the first channel 101 and the second channel 62F is suppressed.

The seal member 73 may be formed of, for example, a synthetic resin. The seal member 73 may be formed of a synthetic resin including, for example, fluorine. The seal member 73 may include, for example, poly tetra fluoroethylene (PTFE).

The second joint section 712 and the third joint section 713 may have the same configuration as the first joint section 711.

That is, in the second joint section 712, the first link member 71 and the second link member 72 are connected such that the first part 621F and the second part 622F of the second channel 62F are connected to each other. At least a portion of the second link member 72 is opposite to the first link member 71 via a gap. A seal member which seals a connecting section of the first part 621F and the second part 622F of the second channel 62F in the second joint section 712 is installed.

In the third joint section 713, the second link member 72 and the relay member 63F are connected such that the second channel 62F (the second part 622F) and the recovery channel 63FR are connected to each other. At least a portion of the relay member 63F is opposite to the second link member 72 via a gap. A seal member which seals a connecting section of the second part 622F of the second channel 62F and the recovery channel 63FR in the third joint section 713 is installed.

The movable member 100 is movable in the XY plane. In the embodiment, the movable member 100 moves in the X axis direction. As the movable member 100 moves in the X axis direction, at least a portion of the connection device 70 relatively moves in the X axis direction with respect to the movable member 100. In the moving range in which the movable member 100 moves, at least a portion of the connection device 70 is relatively movable. For example, in Fig. 20(A), when the movable member 100 moves in the -X axis direction (moves closer to the relay member 63F), the first link member 71 and the movable member 100 relatively move, and the second link member 72 and the relay member 63F relatively move while the first link member 71 and the second link member 72 relatively move so that an angle θ formed by the first link member 71 and the second link member 72 is reduced. When the movable member 100 moves in the +X axis direction (moves away from the relay member 63F), the first link member 71 and the movable member 100 relatively move, and the second link member 72 and the relay member 63F relatively move while the first link member 71 and the second link member 72 relatively moves so that an angle θ formed by the first link member 71 and the second link member 72 is increased.

As described above, according to the embodiment, since the connection device 70, at least a portion of which is relatively movable with respect to the movable member 100, is installed, even when the movable member 100 moves, occurrence of vibrations is suppressed. Accordingly, occurrence of exposure failure and generation of a defective device are suppressed.

### <Seventh embodiment>

A seventh embodiment will be described. In the description below, the same reference numerals are designated to the same or similar components as those of the above-mentioned embodiment, and descriptions thereof will be simplified or omitted.

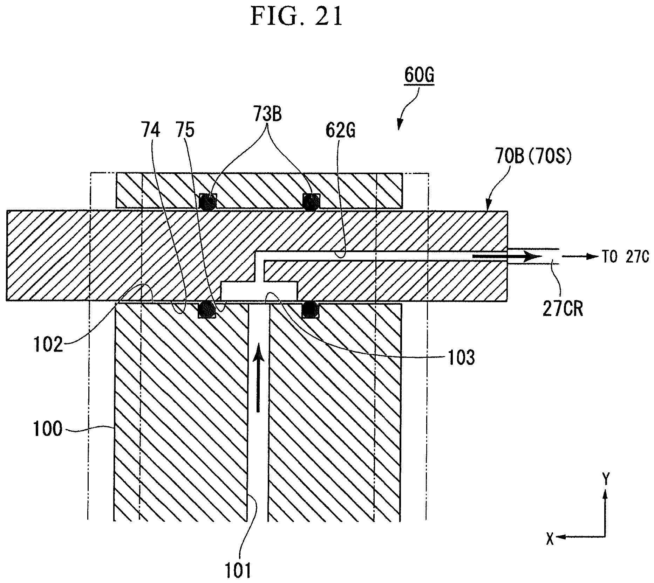

Fig. 21 is a cross-sectional view showing an example of a piping system 60G according to the embodiment. The piping system 60G has a second channel 62G, at least a portion of which is opposite to the movable member 100, and through which the liquid LQ from the first channel 101 of the movable member 100 is able to flow, and includes a connection device 70B, at least a portion of which is relatively movable with respect to the movable member 100. The first channel 101 is connected to the channel 27CR in communication with the liquid recovery apparatus 27C via the second channel 62G.

In the embodiment, the connection device 70B includes a relay member 70S to which at least a portion of the movable member 100 is capable of facing. The second channel 62G is formed at the relay member 70S.

In the embodiment, the movable member 100 moves in the X axis direction. The relay member 70S and the movable member 100 are relatively movable in the X axis direction. The relay member 70S is relatively movable with respect to the movable member 100 in a state in which at least a portion thereof is opposite to the movable member 100.

In the embodiment, at least a portion of the relay member 70S is connected to the support frame 53. A position of the relay member 70S is fixed. Further, the relay member 70S may move with respect to the support frame 53.

The movable member 100 has an opposite surface 102 opposing an outer surface 74 of the relay member 70S. The outer surface 74 and the opposite surface 102 oppose each other via a gap. Further, a gas bearing may be installed between the outer surface 74 and the opposite surface 102.

A hole (through-hole) passing in the X axis direction may be formed at the movable member 100. The relay member 70S may be a rod member disposed inside the through-hole. The outer surface 74 may be an outer surface of the rod member. The opposite surface 102 may be an inner surface of the through-hole formed at the movable member 100.

An end (an opening) 103 of the first channel 101 is disposed in the opposite surface 102. An end (an opening) 75 of the second channel 62G is disposed in the outer surface 74. The opening 75 is larger than the opening 103. The opening 103 has a size such that the opening 75 and the opening 103 can continuously oppose each other even when the movable member 100 moves in the X axis direction in the moving range of the movable member 100.

That is, even when the movable member 100 moves in the X axis direction, the first channel 101 is connected to the second channel 62G. At least a portion of the liquid LQ recovered from the fluid recovery part 27 and introduced into the first channel 101 can flow into the second channel 62G.

The second channel 62G and the liquid recovery apparatus 27C are connected to each other via the channel 27CR. The channel 27CR communicates with the liquid recovery apparatus 27C. The first channel 101 is connected to the channel 27CR in communication with the liquid recovery apparatus 27C via the second channel 62G of the connection device 70B. The liquid LQ from the fluid recovery part 27 is recovered by the liquid recovery apparatus 27C via the first channel 101, the second channel 62G, and the channel 27CR.

The connection device 70B has a seal member 73B which seals a connecting section of the first channel 101 and the second channel 62G. Like the seal member 73 described in the sixth embodiment, the seal member 73B has lubricity or the like. A leakage of the liquid LQ in the connecting section of the first channel 101 and the second channel 62G is suppressed by the seal member 73B.

Further, the opening 75 has a size such that the opening 75 is not opposite the seal member 73B even when the movable member 100 moves in the X axis direction. That is, when the movable member 100 moves in the moving range in the X axis direction, a dimension of the opening 75 in the X axis direction is determined such that the seal member 73B is not disposed inside the opening 75. Further, when the movable member 100 moves, at least a portion of the seal member 73B may be disposed inside the opening 75.

As described above, even in the embodiment, the movable member 100 and the connection device 70B (the relay member 70S) are relatively movable with each other. In addition, the movable member 100 and the connection device 70B (the relay member 70S) are relatively movable in a state in which they are opposing each other via a gap. For this reason, even when the movable member 100 moves, occurrence of vibrations is suppressed. Accordingly, occurrence of exposure failure and generation of a defective device are suppressed.

### <Eighth embodiment>

An eighth embodiment will be described. In the description below, the same reference numerals are designated to the same or similar components as those of the above-mentioned embodiment, and descriptions thereof will be simplified or omitted.

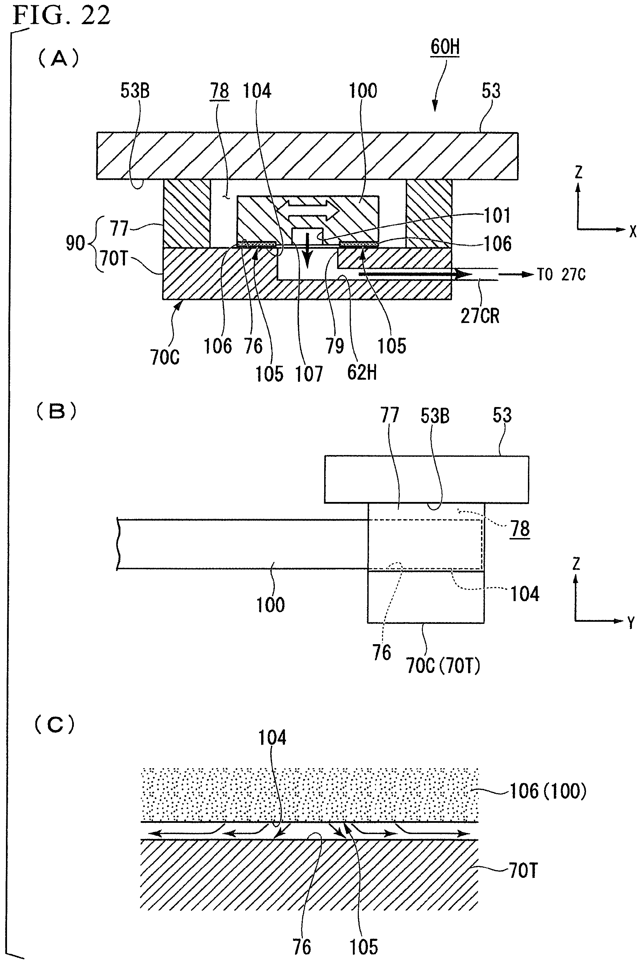

Fig. 22(A) is a cross-sectional view showing an example of a piping system 60H according to the embodiment. Fig. 22(B) is a side view showing an example of the piping system 60H. Fig. 22(C) is a schematic diagram showing a portion of the piping system 60H.

The piping system 60H has a second channel 62H, at least a portion of which is opposite to the movable member 100 and through which the liquid LQ from the first channel 101 of the movable member 100 is able to flow, and includes a connection device 70C, at least a portion of which is relatively movable with respect to the movable member 100. The first channel 101 is connected to the channel 27CR in communication with the liquid recovery apparatus 27C via the second channel 62H.

In the embodiment, the connection device 70C includes a relay member 70T having a support surface 76, to which at least a portion of the movable member 100 is capable of facing and which movably supports the movable member 100. The second channel 62H is formed in the relay member 70T.

In the embodiment, the movable member 100 moves in the X axis direction. The relay member 70T and the movable member 100 are relatively movable in the X axis direction. The relay member 70T is relatively movable with respect to the movable member 100 in a state in which at least a portion thereof is opposite to the movable member 100. The movable member 100 is movable in the X axis direction in a state in which the movable member 100 is supported by the relay member 70T.

In the embodiment, at least a portion of the relay member 70T is connected to the support frame 53. In the embodiment, the relay member 70T is connected to a holding member 77 connected to a lower surface 53B of the support frame 53. The relay member 70T is fixed to the holding member 77. The relay member 70T is connected to the support frame 53 via the holding member 77. A position of the relay member 70T is fixed.

In the description below, the holding member 77 and the relay member 70T connected to the holding member 77 are combined and appropriately referred to as a relay device 90. The relay device 90 is fixed to the support frame 53.

In the embodiment, at least a portion of the movable member 100 is disposed inside a space 78 between the support frame 53 and the relay device 90. The relay device 90 (the relay member 70T) movably supports the movable member 100. Even when the movable member 100 moves in the moving range in the space 78, a size of the space 78 is determined such that the movable member 100 and the holding member 77 do not come in contact with each other.

The movable member 100 has an opposite surface 104 opposing the support surface 76 of the relay member 70T. In the embodiment, the support surface 76 is directed upward (the +Z side). The opposite surface 104 is directed downward (the - Z side).

The support surface 76 and the opposite surface 104 oppose each other via a gap. The support surface 76 supports the movable member 100 in a non-contact manner.

As shown in Fig. 22(C), a gas bearing 105 is installed between the support surface 76 and the opposite surface 104. In the embodiment, the gas bearing 105 is formed by a gas supplied between the support surface 76 and the opposite surface 104 from holes of a porous member 106 disposed at the movable member 100.

The opposite surface 104 includes a lower surface of the porous member 106. Further, the gas bearing 105 may not be formed by the gas supplied from the porous member 106. In order to form the gas bearing 105, an air inlet port which supplies a gas to between the support surface 76 and the opposite surface 104, and an air outlet port which discharges at least a portion of the gas between the support surface 76 and the opposite surface 104 may be formed at one or both of the opposite surface 104 of the movable member 100 and the support surface 76 of the relay member 70T.

An end (an opening) 107 of the first channel 101 is disposed at the opposite surface 104. An end (an opening) 79 of the second channel 62H is disposed at the support surface 76. The opening 79 is larger than the opening 107. The opening 107 has a size such that the opening 79 and the opening 107 continuously oppose each other even when the movable member 100 moves in the X axis direction in the moving range of the movable member 100.

That is, even when the movable member 100 moves in the X axis direction, the first channel 101 is continuously connected to the second channel 62H. At least a portion of the liquid LQ recovered from the fluid recovery part 27 and introduced into the first channel 101 can flow into the second channel 62H.

The second channel 62H and the liquid recovery apparatus 27C are connected to each other via the channel 27CR. The channel 27CR communicates with the liquid recovery apparatus 27C. The first channel 101 is connected to the channel 27CR in communication with the liquid recovery apparatus 27C via the second channel 62H of the connection device 70C. The liquid LQ from the fluid recovery part 27 is recovered by the liquid recovery apparatus 27C via the first channel 101, the second channel 62H, and the channel 27CR.

The connection device 70C has a seal section which seals a connecting section of the first channel 101 and the second channel 62H. In the embodiment, a seal section is formed by the opening 79 and the gas bearing 105 disposed outside the opening 107. A leakage of the liquid LQ in the connecting section of the first channel 101 and the second channel 62H is suppressed by the seal section (the gas bearing 105).

As described above, even in this embodiment, the movable member 100 and the connection device 70C (the relay member 70T) are relatively movable with each other. For this reason, even when the movable member 100 is moved, occurrence of vibrations is suppressed. In addition, the movable member 100 and the connection device 70C (the relay member 70T) are relatively moved in a state in which they oppose each other via a gap. For this reason, a repulsive force generated according to movement of the movable member 100 and applied to a holding device 90 can be reduced. Accordingly, occurrence of exposure failure and generation of a defective device are suppressed.

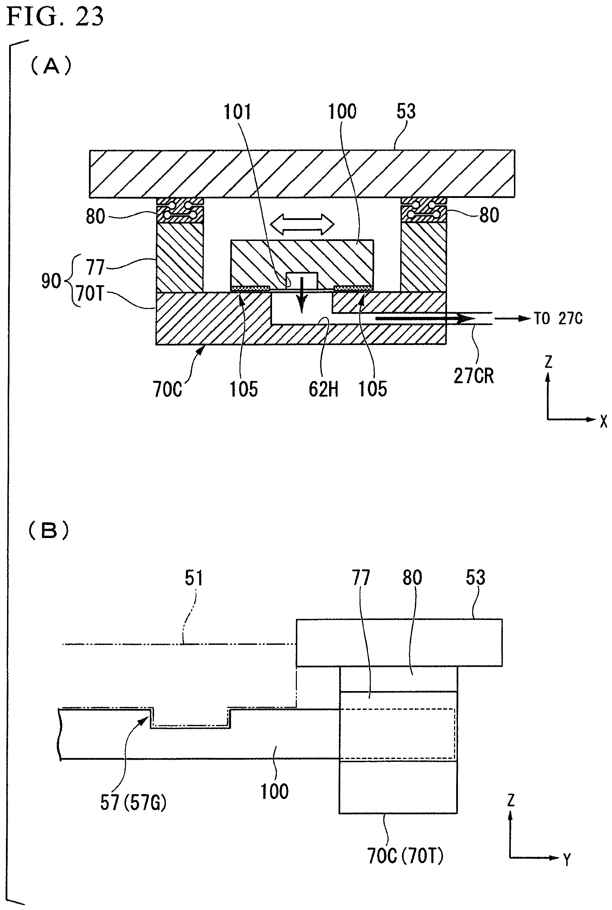

Further, in the embodiment, as shown in Figs. 23(A) and 23(B), a support apparatus 80 which movably (able to swing) supports the relay device 90 may be installed between the support frame 53 and the relay device 90. The support apparatus 80 includes, for example, a hinge mechanism. The support apparatus 80 movably supports the relay device 90, which includes the holding member 77 and the relay member 70T connected to the holding member 77, in six directions including the X axis, Y axis, Z axis, θX, θY, and θZ directions.

As described in the embodiments, the guide apparatus 57 and the gas bearing 57G which guide the movable member 100 (the second member 22, the second support member 52) are installed between the first support member 51 and the movable member 100. The guide apparatus 57 guides the movable member 100 in the X axis direction, and restricts movement of the movable member 100 in the Y axis, Z axis, θX, θY, and θZ axis directions. The movable member 100 is guided by the gas bearing 57G in the X axis direction with respect to the first support member 21 in a non-contact state.

In an example shown in Fig. 23, since the relay device 90 is movable with respect to the support frame 53 by the support apparatus 80, a repulsive force generated according to movement of the movable member 100 and applied to the relay device 90 can be decreased. In addition, since the relay device 90 is movable with respect to the support frame 53, each of the dimension of the gap between the first support member 51 and the movable member 100 in the gas bearing 57G and the dimension of the gap between the relay member 70T and the movable member 100 in the gas bearing 105 can be maintained at an appropriate dimension.

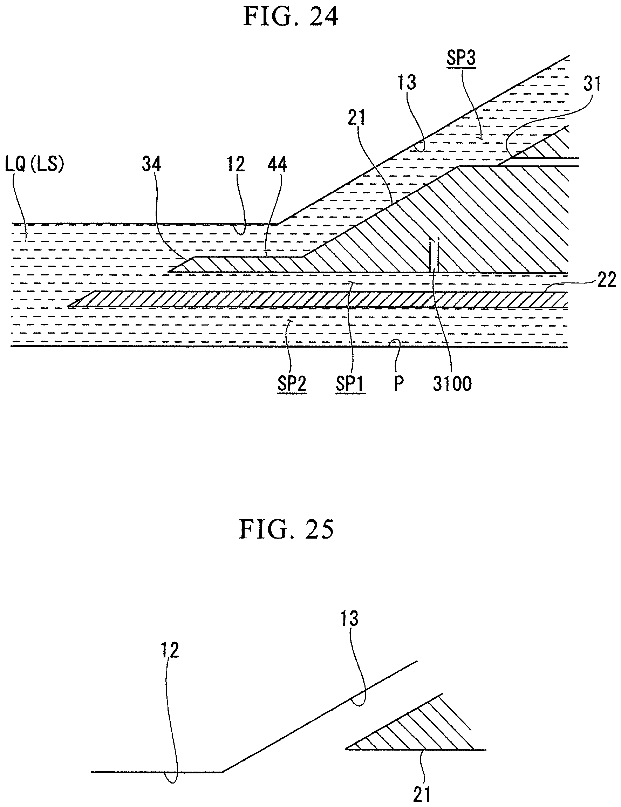

Further, in each of the above-mentioned first to eighth embodiments, as shown in Fig. 24, at least a portion of the first member 21 may be opposite to the emitting surface 12 of the terminal optical element 13. That is, a portion of the first member 21 may be disposed between the emitting surface 12 and the upper surface of the substrate P (the object).

In the example shown in Fig. 24, the first member 21 has an upper surface 44 disposed around the opening 34. The upper surface 44 is disposed around an upper end of the opening 34. In addition, in the example shown in Fig. 24, a portion of the upper surface of the second member 22 is also opposite to the emitting surface 12.

Further, in each of the above-mentioned embodiments, as shown in Fig. 24, a liquid supply part (a liquid supply port) 3100 may be installed to face the first space SP1. In the example shown in Fig. 24, the liquid supply part 3100 is disposed at the lower surface of the first member 21 to face the first space SP1.

Further, the liquid supply part 3100 may be disposed at the upper surface of the second member 22 to face the first space SP1.

As the liquid LQ is supplied from the liquid supply part 3100, for example, even when the liquid LQ supplied from the liquid supply part 31 facing the third space SP3 does not flow into the first space SP1, the first space SP1 is filled with the liquid LQ.

Further, in each of the above-mentioned embodiments, the second member 22 may not be opposite to the emitting surface 12. That is, the second member 22 may not be disposed between the emitting surface 12 and the upper surface of the substrate P (the object). For example, as shown in Fig. 25, the lower surface of the first member 21 may be disposed at the +Z side of the emitting surface 12. That is, the dimension of the gap between the upper surface of the substrate P (the object) and the emitting surface 12 may be smaller than the dimension of the gap between the upper surface of the substrate P and the lower surface of the second member 22.

Further, in each of the above-mentioned embodiments, a position (a height) of the lower surface of the first member 21 in the Z axis direction may be substantially equal to a position (a height) of the emitting surface 12. The lower surface of the first member 21 may be disposed at the -Z side of the emitting surface 12.

Further, in each of the above-mentioned embodiments, the dimension of the gap between the upper surface of the substrate P (the object) and the emitting surface 12 may be substantially equal to the dimension of the gap between the upper surface of the substrate P and the lower surface of the second member 22.

Further, in each of the above-mentioned embodiments, a suction port which suctions at least one of the liquid LQ and the gas from the space between the first member 21 and the terminal optical element 13 may be installed at the first member 21.

Further, in each of the above-mentioned embodiments, the first member 21 may not have an annular shape. For example, the first member 21 may be disposed at a portion of the surrounding of the terminal optical element 13 (the optical path K). For example, the plurality of first members 21 may be disposed around the terminal optical element 13 (the optical path K).

Further, in each of the above-mentioned embodiments, the controller 6 includes a computer system which includes a CPU or the like. In addition, the controller 6 includes an interface which is able to perform communication with a computer system and an external device. For example, the storage device 7 includes a memory such as a RAM, a hard disk, and a recording medium such as a CD-ROM. In the storage device 7, an operating system (OS) which controls the computer system is installed and a program of controlling the exposure apparatus EX is stored.

Further, an input device which is able to input signals may be connected to the controller 6. The input device includes an input instrument such as a keyboard, a mouse, or the like, or a communication device or the like which is able to input data from the external device. In addition, a display device such as a liquid crystal display or the like may also be provided.

The controller (a computer system) 6 is able to read various types of information which include the programs which are recorded in the storage device 7. The programs which cause the controller 6 to perform the control of the liquid immersion exposure apparatus which exposes the substrate with the exposure light via the liquid filled in the optical path of the exposure light between the emitting surface of the optical member from which the exposure light is emitted and the substrate are recorded in the storage device 7.

According to the above-mentioned embodiments, the programs which are recorded in the storage device 7 may cause the controller 6 to perform: forming a liquid immersion space of the liquid on the substrate movable below the optical member by using a liquid immersion member (i) that is disposed at at least surrounding of an optical path of the exposure light, (ii) that is configured to form the liquid immersion space of the liquid on an object movable at below the optical member, and (iii) that comprisies a movable member which comprises a recovery part configured to recover at least a portion of the liquid in the liquid immersion space, and a first channel configured to flow the liquid from the recovery part; exposing the substrate with the exposure light emitted from the emitting surface via the liquid in the liquid immersion space; moving the movable member in at least a part of the exposure processing of the substrate; and recovering the liquid recovered from the recovery part and flowing through the first channel via a second channel of a deformation member connected to the movable member and at least a portion of which is deformable.

In addition, according to the above-mentioned embodiments, the programs which are recorded in the storage device 7 may cause the controller 6 to perform: forming a liquid immersion space of the liquid on the substrate movable below the optical member by using a liquid immersion member (i) that is disposed at at least surrounding of an optical path of the exposure light, (ii) that is configured to form the liquid immersion space of the liquid on an object movable at below the optical member, and (iii) that comprisies a movable member which comprises a recovery part configured to recover at least a portion of the liquid in the liquid immersion space, and a first channel configured to flow the liquid from the recovery part; exposing the substrate with the exposure light emitted from the emitting surface via the liquid in the liquid immersion space; moving the movable member in at least a part of the exposure processing of the substrate; and recovering the liquid recovered from the recovery part and flowing through the first channel by a liquid recovery apparatus via a second channel of a connection device and a third channel connected to the first channel via the second channel, the connection device being configured to have at least a portion thereof which faces the movable member and being configured to have at least a portion thereof which is relatively movable with respect to the movable member.

The programs which are stored in the storage device 7 are read by the controller 6, and thus, various devices of the exposure apparatus EX such as the substrate stage 2, the measurement stage 3, the liquid immersion member 5, and so on, cooperate with one another and perform various processing such as the liquid immersion exposure or the like of the substrate P in the state in which the liquid immersion space LS is formed.

Moreover, in each of the above-mentioned embodiments, the optical path K on the emitting surface 12 side (the image surface side) of the terminal optical element 13 of the projection optical system PL is filled with the liquid LQ. However, for example, the projection optical system PL may be the projection optical system in which the optical path of the incident side (the object surface side) at the terminal optical element 13 is also filled with the liquid LQ as disclosed in PCT International Publication No. WO 2004/019128.

Further, in each of the above-mentioned embodiments, the liquid LQ is water. However, the liquid may be a liquid other than the water. Preferably, the liquid LQ is transparent with respect to the exposure light EL, has a high refractive index with respect to the exposure light EL, and is stable with respect to the projection optical system PL or the film of a photosensitive material (photoresist) which forms the surface of the substrate P or the like. For example, the liquid LQ may be fluorinated liquid such as hydrofluoroether (HFE), perfluorinated polyether (PFPE), and Fomblin® oil. Moreover, the liquid LQ may be various fluids, such as, for example, a supercritical liquid.

Further, in each of the above-mentioned embodiment, the substrate P includes a semiconductor wafer used to manufacture a semiconductor device. However, for example, the substrate P includes a glass substrate for a display device, a ceramic wafer for a thin film magnetic head, a mask or an original plate (synthetic quartz, a silicon wafer) of a reticle which is used in an exposure apparatus, or the like.

Further, in each of the above-mentioned embodiments, the exposure apparatus EX is a scanning type exposure apparatus (a scanning stepper) of a step-and-scan system in which the mask M and the substrate P synchronously move and the patterns of the mask M are scanned and exposed. However, for example, the exposure apparatus EX may be a projection exposure apparatus (a stepper) of a step-and-repeat system in which patterns of the mask M are collectively exposed in a state where the mask M and the substrate P are stationary and the substrate P is sequentially step-moved.

In addition, the exposure apparatus EX may be an exposure apparatus (a collective exposure apparatus of a stitch system) in which, in the exposure of a step-and-repeat system, after the reduced image of a first pattern is transferred on the substrate P using the projection optical system in a state where the first pattern and the substrate P are substantially stationary, the reduced image of a second pattern is partially superimposed on the first pattern using the projection optical system and is collectively exposed on the substrate P in a state where the second pattern and the substrate P are substantially stationary. Moreover, the exposure apparatus of the stitch system may be an exposure apparatus of a step-and-stitch system in which at least two patterns are partially superimposed on the substrate P and transferred thereto, and the substrate P is sequentially moved.

In addition, for example, the exposure apparatus EX may be an exposure apparatus in which patterns of two masks are combined on the substrate via the projection optical system and one shot region on the substrate is approximately simultaneously double-exposed by single scanning exposure, as disclosed in United States Patent No. 6,611,316. Moreover, the exposure apparatus EX may be an exposure apparatus of a proximity system, a mirror projection aligner, or the like.

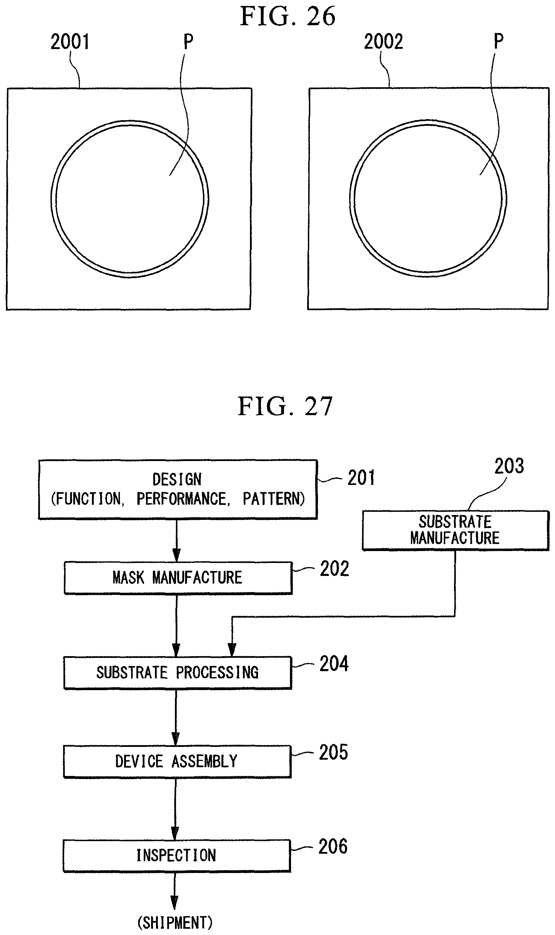

In addition, in each of the above-mentioned embodiments, the exposure apparatus EX may be an exposure apparatus of a twin stage type which includes a plurality of substrate stages, as disclosed in United States Patent No. 6,341,007, United States Patent No. 6,208,407, United States Patent No. 6,262,796, or the like. For example, as shown in FIG 26, when the exposure apparatus EX includes two substrate stages 2001 and 2002, the object which is able to be disposed opposite the emitting surface 12 includes at least one of a substrate on one substrate stage, a substrate which is held by a first holding part of the one substrate stage, a substrate on another substrate stage, and a substrate which is held by a first holding part of another substrate stage.

Moreover, the exposure apparatus EX may be an exposure apparatus which includes the plurality of substrate stages and measurement stages.

The exposure apparatus EX may be an exposure apparatus used to manufacture a semiconductor element which exposes a semiconductor element pattern on the substrate P, an exposure apparatus used to manufacture a liquid crystal display element or a display, or an exposure apparatus used to manufacture a thin film magnetic head, an imaging element (CCD), a micromachine, a MEMS, a DNA chip, or a reticle or mask, or the like.

Moreover, in each of the above-mentioned embodiments, the light transmission type mask is used in which a predetermined light shielding pattern (or a phase pattern, a dimming pattern) is formed on the substrate having light transparency. However, instead of this mask, for example, as disclosed in United States Patent No. 6,778,257, a variable molding mask (also referred to as an electronic mask, an active mask, or an image generator) may be used which forms a transparent pattern, a reflective pattern, or a light-emitting pattern based on electronic data of the pattern to be exposed. In addition, instead of the variable molding masks which include a non-light emission type image display element, a pattern-forming apparatus which includes a self light-emission type image display element may be provided.

In each of the above-mentioned embodiments, the exposure apparatus EX includes the projection optical system PL. However, the components in each of the above-mentioned embodiments may be applied to an exposure apparatus and an exposing method which do not use the projection optical system PL. For example, the components in each of the above-mentioned embodiments may be applied to an exposure apparatus and an exposing method in which the liquid immersion space is formed between an optical member such as a lens and the substrate and the exposure light is radiated to the substrate via the optical member.

Moreover, for example, the exposure apparatus EX may be an exposure apparatus (a lithography system) in which interference fringes are formed on the substrate P, and thus, a line-and-space pattern is exposed on the substrate P, as disclosed in PCT International Publication No. WO 2001/035168.

The exposure apparatuss EX of the above-mentioned embodiments are manufactured by assembling various subsystems including each above-mentioned component so as to maintain predetermined mechanical accuracy, electrical accuracy, and optical accuracy. In order to secure the various accuracies, before and after the assembly, an adjustment for achieving optical accuracy with respect to various optical systems, an adjustment for achieving mechanical accuracy with respect to various mechanical systems, and an adjustment for achieving electrical accuracy with respect to various electrical systems are performed. The process of assembling the exposure apparatus from various subsystems includes mechanical connections, wiring connections of electric circuits, piping connections of air-pressure circuits, or the like between various subsystems. Of course, the respective assembly processes of each subsystem are needed before the assembly process from various subsystems to the exposure apparatus. After the assembly process of exposure apparatus by various subsystems is terminated, a general adjustment is performed, and thus, various accuracies in the overall exposure apparatus are secured. Moreover, preferably, the manufacturing of the exposure apparatus is performed in a clean room in which temperature, a degree of cleanliness, or the like is controlled.

As shown in Fig. 27, a micro-device such as a semiconductor device is manufactured through a step 201 in which the function and performance design of the micro-device is performed, a step 202 in which a mask (a reticle) is prepared based on the design step, a step 203 in which a substrate which is a base material of the device is manufactured, a substrate processing step 204 which includes the substrate processing (exposure processing) including exposing the substrate with the exposure light from the pattern of the mask and developing the exposed substrate according to the above-mentioned embodiments, a device assembly step (which includes manufacturing processes such as a dicing process, a bonding process, and a package process) 205, an inspection step 206, or the like.

Moreover, the aspects of each of the above-mentioned embodiments may be appropriately combined. In addition, some components may not be used.

### [Description of Reference Symbols]

2...substrate stage, 3...measurement stage, 5...liquid immersion member, 6...controller, 7...storage device, 8A...reference frame, 8B...apparatus frame, 12...emitting surface, 13...terminal optical element, 21...first member, 22...second member, 23...lower surface, 24...fluid recovery part, 25...upper surface, 26...lower surface, 27...fluid recovery part, 27C...fluid recovery apparatus, 27CR...channel, 29...outer side surface, 30...inner side surface, 31...liquid supply part, 32...driving apparatus, 34...opening, 35...opening, 36...porous member, 37...porous member, 51...first support member, 52...second support member, 53...support frame, 54...movememt frame, 55...vibration isolator, 56...driving apparatus, 60...piping system, 61...deformation member, 62...second channel, 62F...second channel, 621F...first part, 622F...second part, 63...relay member, 63R...recovery channel, 70...connection device, 70R...link mechanism, 71...first link member, 72...second link member, 100...movable member, 101...first channel, 611...flexible part, 612...curved section, 711...firstjoint section, 712...second joint section, 713...third joint section, EL...exposure light, EX...exposure apparatus, GS...gas, IL...illumination system, K...optical path, LQ...liquid, LS...liquid immersion space, P...substrate

## Claims

1. An exposure apparatus (EX) for exposing a substrate (P) with exposure light (EL) via a liquid (LQ), the exposure apparatus comprising:
an optical member (13) having an emitting surface (12) from which the exposure light is emitted;
a liquid immersion member (5) that is disposed at at least a portion of surrounding of an optical path (K) of the exposure light, that is configured to form a liquid immersion space (LS) of the liquid on an object movable below the optical member, and that has a movable member (100) including a recovery part (27) and a first channel (27R), the recovery part being opposite to the object and configured to recover at least a portion of the liquid in the liquid immersion space, the first channel being configured to flow the liquid from the recovery part; and
a deformation member (61) that (i) is connected to the movable member, (ii) has a second channel (62) configured to flow the liquid from the first channel, and (iii) has at least a portion which is deformable,
wherein the apparatus is configured to expose the substrate with the exposure light via the liquid in the liquid immersion space covering a portion of an upper surface of the substrate,
wherein a portion of the liquid immersion space is formed between the movable member and the object, and
wherein the movable member is arranged to move in a plane perpendicular to an optical axis of the optical member and to move relative to the optical axis such that a relative movement speed with respect to the object is decreased.

2. The exposure apparatus according to claim 1,
wherein the deformation member is elastically deformable in a moving range in which the movable member is arranged to move.

3. The exposure apparatus according to claim 1 or 2,
wherein the deformation member being deformable in a movement direction of the movable member.

4. The exposure apparatus according to any one of claims 1 to 3,
wherein the deformation member comprises a tube member (61) having a flexible part at at least a portion thereof.

5. The exposure apparatus according to any one of claims 1 to 4, further comprising:
a reference frame (8A) configured to support the optical member;
a support frame (53, 54) configured to support at least a portion of the liquid immersion member;
and an apparatus frame (8B) configured to support the reference frame and the support frame,
wherein the deformation member is supported by the support frame.

6. The exposure apparatus according to claim 5, further comprising:
a vibration isolator (10) arranged between the reference frame and the apparatus frame.

7. The exposure apparatus according to claim 5 or 6, further comprising:
a further vibration isolator (55), at least a portion of which is arranged between the support frame and the apparatus frame.

8. An exposure apparatus (EX) for exposing a substrate (P) with exposure light (EL) via a liquid (LQ), the exposure apparatus comprising:
an optical member (13) having an emitting surface (12) from which the exposure light is emitted;
a liquid immersion member (5) that is disposed at at least a portion of surrounding of an optical path (K) of the exposure light, that is configured to form a liquid immersion space (LS) of the liquid on an object movable below the optical member, and that has a movable member (100) including a recovery part (27) and a first channel (27R), the recovery part being opposite to the object and configured to recover at least a portion of the liquid in the liquid immersion space, the first channel being configured to flow the liquid from the recovery part; and
a connecting device (70) that (i) is configured to have at least a portion thereof which faces the movable member, (ii) has a second channel (62F) configured to flow the liquid from the first channel, and (iii) is configured to have at least a portion thereof which is relatively movable with respect to the movable member,
wherein the first channel is connected to a third channel (63FR) via the second channel, the third channel being in communication with a liquid recovery apparatus (27C)
wherein the substrate is exposed with the exposure light via the liquid in the liquid immersion space covering a portion of an upper surface of the substrate,
wherein a portion of the liquid immersion space is formed between the movable member and the object, and
wherein the movable member is arranged to move in a plane perpendicular to an optical axis of the optical member and is arranged to move relative to the optical axis such that a relative movement speed with respect to the object is decreased.

9. The exposure apparatus according to claim 8,
wherein the connection device has a link mechanism (70R) comprising (i) a first link member (71) which is connected to the movable member via a first joint section (711) and in which a first part (621F) of the second channel is formed, and (ii) a second link member (72) which is connected to the first link member via a second joint section (712) and in which a second part (622F) of the second channel is formed.

10. The exposure apparatus according to claim 8 or 9, further comprising:
a reference frame (8A) configured to support the optical member;
a support frame (53, 54) configured to support at least a portion of the liquid immersion member; and
an apparatus frame (8B) configured to support the reference frame and the support frame,
wherein the connection device is supported by the support frame.

11. The exposure apparatus according to claim 9, further comprising:
a vibration isolator (10) arranged between the reference frame and the apparatus frame.

12. The exposure apparatus according to claim 9 or 10, further comprising:
a further vibration isolator (55) at least a portion of which is arranged between the support frame and the apparatus frame.

13. The exposure apparatus according to any one of claims 1 to 11,
wherein the movable member is movable in a state in which the liquid immersion space is formed.

14. The exposure apparatus according to any one of claims 1 to 12,
wherein the movable member is movable in at least a part of a period in which the exposure light is emitted from the emitting surface.

15. The exposure apparatus according to any one of claims 1 to 13,
wherein the movable member is moved such that a relative movement speed between the movable member and the object becomes smaller than a relative movement speed between the optical member and the object.

16. The exposure apparatus according to any one of claims 1 to 15,
wherein the movable member is movable in the same direction as the object is moved to decrease the relative movement speed between the movable member and the object.

17. The exposure apparatus according to any one of claims 1 to 16,
wherein the object comprises the substrate,
in a state in which the liquid immersion space is formed, the substrate moves along a first pathway (Tp1) and then moves along a second pathway (Tp2) in a plane substantially perpendicular to an optical axis of the optical member, movement of the substrate in the first pathway comprises movement in a first direction substantially parallel to a first axis (Y) in the plane, and movement of the substrate in the second pathway comprises movement in a second direction substantially parallel to a second axis (X) perpendicular to the first axis in the plane and movement in a third direction substantially parallel to a third axis perpendicular to the second axis in the plane.

18. The exposure apparatus according to claim 17,
wherein the exposure light is radiated to a shot region of the substrate via the liquid in the liquid immersion space when the substrate moves along the first pathway, and the exposure light is not radiated when the substrate moves along the second pathway.

19. The exposure apparatus according to claim 17 or 18,
wherein the substrate moves along the second pathway and moves along a third pathway,
in the third pathway, movement of the substrate comprises movement in the third direction opposite to the first direction, and
the movable member moves in a fourth direction opposite to the second direction in at least a part of a period in which the substrate moves along the third pathway.

20. The exposure apparatus according to any one of claims 1 to 19, wherein the liquid immersion member has a first member (21) which is disposed at at least a portion of surrounding of the optical member,
and a second member (22) which is disposed to be opposite to the object and which configured to be movable with respect to the first member, and
the movable member comprises the second member.

21. The exposure apparatus according to claim 20,
wherein each of the first member and the second member has an opening (34, 35) through which the exposure beam is allowed to pass.

22. The exposure apparatus according to claim 20 or 21,
wherein a liquid supply part (31) via which the liquid is supplied is formed at at least one of the first member and the second member.

23. An exposure method for exposing a substrate with exposure light via a liquid, the method comprising:
emitting exposure light from an emitting surface of an optical member;
forming a liquid immersion space of the liquid on an object movable below the optical member with a liquid immersion member that is disposed at at least a portion of surrounding of an optical path of the exposure light,
which liquid immersion member has a movable member including a recovery part and a first channel, the recovery part being opposite to the object and recovering at least a portion of the liquid in the liquid immersion space, the first channel flowing the liquid from the recovery part,
a deformation member (i) being connected to the movable member, (ii) having a second channel flowing the liquid from the first channel, and (iii) having at least a portion which deforms;
exposing the substrate with the exposure light via the liquid in the liquid immersion space covering a portion of an upper surface of the substrate,
wherein a portion of the liquid immersion space is formed between the movable member and the object, and
wherein the movable member moves in a plane perpendicular to an optical axis of the optical member and moves relative to the optical axis such that a relative movement speed with respect to the object is decreased.

24. An exposure method for exposing a substrate with exposure light via a liquid, the method comprising:
emitting exposure light from an emitting surface of an optical member;
forming a liquid immersion space of the liquid on an object movable below the optical member with a liquid immersion member that is disposed at at least a portion of surrounding of an optical path of the exposure light,
which liquid immersion member has a movable member including a recovery part and a first channel, the recovery part being opposite to the object and recovering at least a portion of the liquid in the liquid immersion space, the first channel flowing the liquid from the recovery part,
a connecting device (i) having at least a portion thereof which faces the movable member, (ii) having a second channel flowing the liquid from the first channel, and (iii) having at least a portion thereof which relatively moves with respect to the movable member,
the first channel being connected to a third channel via the second channel, the third channel being in communication with a liquid recovery apparatus; and
exposing the substrate with the exposure light via the liquid in the liquid immersion space covering a portion of an upper surface of the substrate,
wherein a portion of the liquid immersion space is formed between the movable member and the object, and
wherein the movable member is moved in a plane perpendicular to an optical axis of the optical member and is moved relative to the optical axis such that a relative movement speed with respect to the object is decreased.

25. A device manufacturing method comprising:
exposing a substrate using the exposure method according to claim 23 or 24 or the exposure apparatus according to any one of claims 1 to 22; and
developing the exposed substrate.

## Patentansprüche

1. Belichtungsvorrichtung (EX) zum Belichten eines Substrats (P) mit Belichtungslicht (EL) über eine Flüssigkeit (LQ), wobei die Belichtungsvorrichtung umfasst:
ein optisches Element (13), das eine emittierende Fläche (12) aufweist, von der das Belichtungslicht emittiert wird;
ein Flüssigkeitsimmersionselement (5), das bei zumindest einem Abschnitt einer Umgebung eines Strahlengangs (K) des Belichtungslichts angeordnet ist, das eingerichtet ist, einen Flüssigkeitsimmersionsraum (LS) der Flüssigkeit auf einem Objekt zu bilden, das unterhalb des optischen Elements bewegbar ist, und das ein bewegbares Element (100) einschließlich eines Rückgewinnteils (27) und eines ersten Kanals (27R) aufweist, wobei der Rückgewinnteil dem Objekt gegenüberliegt und eingerichtet ist, zumindest einen Abschnitt der Flüssigkeit im Flüssigkeitsimmersionsraum rückzugewinnen, wobei der erste Kanal eingerichtet ist, die Flüssigkeit vom Rückgewinnteil zu transportieren; und
ein Verformungselement (61), das (i) mit dem bewegbaren Element verbunden ist, (ii) einen zweiten Kanal (62) aufweist, der eingerichtet ist, die Flüssigkeit vom ersten Kanal zu transportieren, und (iii) zumindest einen Abschnitt aufweist, der verformbar ist,
wobei die Vorrichtung eingerichtet ist, das Substrat mit dem Belichtungslicht über die Flüssigkeit im Flüssigkeitsimmersionsraum zu belichten, der einen Abschnitt einer oberen Fläche des Substrats abdeckt,
wobei ein Abschnitt des Flüssigkeitsimmersionsraums zwischen dem bewegbaren Element und dem Objekt gebildet ist, und
wobei das bewegbare Element angeordnet ist, sich in einer Ebene senkrecht zu einer optischen Achse des optischen Elements zu bewegen und sich relativ zur optischen Achse zu bewegen, sodass eine relative Bewegungsgeschwindigkeit in Bezug auf das Objekt verringert wird.

2. Belichtungsvorrichtung nach Anspruch 1,
wobei das Verformungselement in einem Bewegungsbereich elastisch verformbar ist, in dem das bewegbare Element angeordnet ist, sich zu bewegen.

3. Belichtungsvorrichtung nach Anspruch 1 oder 2, wobei
das Verformungselement in einer Bewegungsrichtung des bewegbaren Elements verformbar ist.

4. Belichtungsvorrichtung nach einem der Ansprüche 1 bis 3, wobei das Verformungselement ein Rohrelement (61), das einen flexiblen Teil bei zumindest einem Abschnitt davon aufweist, umfasst.

5. Belichtungsvorrichtung nach einem der Ansprüche 1 bis 4, weiter umfassend:
einen Referenzrahmen (8A), der eingerichtet ist, das optische Element zu stützen;
einen Stützrahmen (53, 54), der eingerichtet ist, zumindest einen Abschnitt des Flüssigkeitsimmersionselements zu stützen; und
einen Vorrichtungsrahmen (8B), der eingerichtet ist, den Referenzrahmen und den Stützrahmen zu stützen,
wobei das Verformungselement durch den Stützrahmen gestützt wird.

6. Belichtungsvorrichtung nach Anspruch 5, weiter umfassend:
einen Vibrationsisolator (10), der zwischen dem Referenzrahmen und dem Vorrichtungsrahmen angeordnet ist.

7. Belichtungsvorrichtung nach Anspruch 5 oder 6, weiter umfassend:
einen weiteren Vibrationsisolator (55), von dem zumindest ein Abschnitt zwischen dem Stützrahmen und dem Vorrichtungsrahmen angeordnet ist.

8. Belichtungsvorrichtung (EX) zum Belichten eines Substrats (P) mit Belichtungslicht (EL) über eine Flüssigkeit (LQ), wobei die Belichtungsvorrichtung umfasst:
ein optisches Element (13), das eine emittierende Fläche (12) aufweist, von der das Belichtungslicht emittiert wird;
ein Flüssigkeitsimmersionselement (5), das bei zumindest einem Abschnitt einer Umgebung eines Strahlengangs (K) des Belichtungslichts angeordnet ist, das eingerichtet ist, einen Flüssigkeitsimmersionsraum (LS) der Flüssigkeit auf einem Objekt zu bilden, das unterhalb des optischen Elements bewegbar ist, und das ein bewegbares Element (100) einschließlich eines Rückgewinnteils (27) und eines ersten Kanals (27R) aufweist, wobei der Rückgewinnteil dem Objekt gegenüberliegt und eingerichtet ist, zumindest einen Abschnitt der Flüssigkeit im Flüssigkeitsimmersionsraum rückzugewinnen, wobei der erste Kanal eingerichtet ist, die Flüssigkeit vom Rückgewinnteil zu transportieren; und
eine Verbindungsvorrichtung (70), die (i) eingerichtet ist, zumindest einen Abschnitt davon aufzuweisen, der dem bewegbaren Element zugewandt ist, (ii) einen zweiten Kanal (62F) aufweist, der eingerichtet ist, die Flüssigkeit vom ersten Kanal zu transportieren, und (iii) eingerichtet ist, zumindest einen Abschnitt davon aufzuweisen, der relativ in Bezug auf das bewegbare Element bewegbar ist,
wobei der erste Kanal mit einem dritten Kanal (63FR) über den zweiten Kanal verbunden ist, wobei der dritte Kanal in Verbindung mit einer Flüssigkeitsrückgewinnvorrichtung (27C) steht,
wobei das Substrat mit dem Belichtungslicht über die Flüssigkeit im Flüssigkeitsimmersionsraum belichtet wird, der einen Abschnitt einer oberen Fläche des Substrats abdeckt,
wobei ein Abschnitt des Flüssigkeitsimmersionsraums zwischen dem bewegbaren Element und dem Objekt gebildet ist, und
wobei das bewegbare Element angeordnet ist, sich in einer Ebene senkrecht zu einer optischen Achse des optischen Elements zu bewegen und angeordnet ist, sich relativ zur optischen Achse zu bewegen, sodass eine relative Bewegungsgeschwindigkeit in Bezug auf das Objekt verringert wird.

9. Belichtungsvorrichtung nach Anspruch 8,
wobei die Verbindungsvorrichtung einen Gestängemechanismus (70R) aufweist, umfassend (i) ein erstes Gestängeelement (71), das mit dem bewegbaren Element über einen ersten Gelenkteilabschnitt (711) verbunden ist und in dem ein erster Teil (621F) des zweiten Kanals gebildet ist, und (ii) ein zweites Gestängeelement (72), das mit dem ersten Gestängeelement über einen zweiten Gelenkteilabschnitt (712) verbunden ist und in dem ein zweiter Teil (622F) des zweiten Kanals gebildet ist.

10. Belichtungsvorrichtung nach Anspruch 8 oder 9, weiter umfassend:
einen Referenzrahmen (8A), der eingerichtet ist, das optische Element zu stützen;
einen Stützrahmen (53, 54), der eingerichtet ist, zumindest einen Abschnitt des Flüssigkeitsimmersionselements zu stützen; und
einen Vorrichtungsrahmen (8B), der eingerichtet ist, den Referenzrahmen und den Stützrahmen zu stützen,
wobei die Verbindungsvorrichtung durch den Stützrahmen gestützt wird.

11. Belichtungsvorrichtung nach Anspruch 9, weiter umfassend:
einen Vibrationsisolator (10), der zwischen dem Referenzrahmen und dem Vorrichtungsrahmen angeordnet ist.

12. Belichtungsvorrichtung nach Anspruch 9 oder 10, weiter umfassend:
einen weiteren Vibrationsisolator (55), von dem zumindest ein Abschnitt zwischen dem Stützrahmen und dem Vorrichtungsrahmen angeordnet ist.

13. Belichtungsvorrichtung nach einem der Ansprüche 1 bis 11,
wobei das bewegbare Element in einem Zustand bewegbar ist, in dem der Flüssigkeitsimmersionsraum gebildet ist.

14. Belichtungsvorrichtung nach einem der Ansprüche 1 bis 12,
wobei das bewegbare Element in zumindest einem Teil eines Zeitraums bewegbar ist, in der das Belichtungslicht von der emittierenden Fläche emittiert wird.

15. Belichtungsvorrichtung nach einem der Ansprüche 1 bis 13,
wobei das bewegbare Element so bewegt wird, dass eine relative Bewegungsgeschwindigkeit zwischen dem bewegbaren Element und dem Objekt kleiner wird als eine relative Bewegungsgeschwindigkeit zwischen dem optischen Element und dem Objekt.

16. Belichtungsvorrichtung nach einem der Ansprüche 1 bis 15,
wobei das bewegbare Element in derselben Richtung bewegbar ist wie das Objekt bewegt wird, um die relative Bewegungsgeschwindigkeit zwischen dem bewegbaren Element und dem Objekt zu verringern.

17. Belichtungsvorrichtung nach einem der Ansprüche 1 bis 16,
wobei das Objekt das Substrat umfasst,
in einem Zustand, in dem der Flüssigkeitsimmersionsraum gebildet ist, sich das Substrat entlang eines ersten Pfads (Tp1) bewegt und sich dann entlang eines zweiten Pfads (Tp2) in einer Ebene im Wesentlichen senkrecht zu einer optischen Achse des optischen Elements bewegt, Bewegung des Substrats im ersten Pfad Bewegung in eine erste Richtung im Wesentlichen parallel zu einer ersten Achse (Y) in der Ebene umfasst und Bewegung des Substrats im zweiten Pfad Bewegung in einer zweiten Richtung im Wesentlichen parallel zu einer zweiten Achse (X) senkrecht zur ersten Achse in der Ebene und Bewegung in einer dritten Richtung im Wesentlichen parallel zu einer dritten Achse senkrecht zur zweiten Achse in der Ebene umfasst.

18. Belichtungsvorrichtung nach Anspruch 17,
wobei das Belichtungslicht auf einen Schussbereich des Substrats über die Flüssigkeit im Flüssigkeitsimmersionsraum abgestrahlt wird, wenn das Substrat sich entlang des ersten Pfads bewegt und das Belichtungslicht nicht abgestrahlt wird, wenn das Substrat sich entlang des zweiten Pfads bewegt.

19. Belichtungsvorrichtung nach Anspruch 17 oder 18,
wobei das Substrat sich entlang des zweiten Pfads bewegt und sich entlang eines dritten Pfads bewegt,
im dritten Pfad Bewegung des Substrats Bewegung in der dritten Richtung entgegengesetzt zur ersten Richtung umfasst, und
das bewegbare Element sich in einer vierten Richtung entgegengesetzt zur zweiten Richtung in zumindest einem Teil eines Zeitraums bewegt, in der das Substrat sich entlang des dritten Pfads bewegt.

20. Belichtungsvorrichtung nach einem der Ansprüche 1 bis 19,
wobei das Flüssigkeitsimmersionselement ein erstes Element (21), das bei zumindest einem Abschnitt einer Umgebung des optischen Elements angeordnet ist, und ein zweites Element (22) aufweist, das angeordnet ist, dem Objekt gegenüberzuliegen, und das eingerichtet ist, in Bezug auf das erste Element bewegbar zu sein, und
das bewegbare Element das zweite Element umfasst.

21. Belichtungsvorrichtung nach Anspruch 20,
wobei jedes des ersten Elements und des zweiten Elements eine Öffnung (34, 35) aufweist, durch die ein Hindurchgehen des Belichtungsstrahls erlaubt ist.

22. Belichtungsvorrichtung nach Anspruch 20 oder 21,
wobei ein Flüssigkeitszuführteil (31), über den die Flüssigkeit zugeführt wird, an zumindest einem des ersten Elements und des zweiten Elements gebildet ist.

23. Belichtungsverfahren zum Belichten eines Substrats mit Belichtungslicht über eine Flüssigkeit, wobei das Verfahren umfasst:
Emittieren von Belichtungslicht von einer emittierenden Fläche eines optischen Elements;
Bilden eines Flüssigkeitsimmersionsraums der Flüssigkeit auf einem Objekt, das unterhalb des optischen Elements bewegbar ist, mit einem Flüssigkeitsimmersionselement, das bei zumindest einem Abschnitt einer Umgebung eines Strahlengangs des Belichtungslichts angeordnet ist,
welches Flüssigkeitsimmersionselement ein bewegbares Element einschließlich eines Rückgewinnteils und eines ersten Kanals aufweist, wobei der Rückgewinnteil dem Objekt gegenüberliegt und zumindest einen Abschnitt der Flüssigkeit im Flüssigkeitsimmersionsraum rückgewinnt, wobei der erste Kanal die Flüssigkeit vom Rückgewinnteil transportiert,
ein Verformungselement, das (i) mit dem bewegbaren Element verbunden ist, (ii) einen zweiten Kanal aufweist, der die Flüssigkeit vom ersten Kanal transportiert und (iii) zumindest einen Abschnitt aufweist, der sich verformt;
Belichten des Substrats mit dem Belichtungslicht über die Flüssigkeit im Flüssigkeitsimmersionsraum, der einen Abschnitt einer oberen Fläche des Substrats abdeckt,
wobei ein Abschnitt des Flüssigkeitsimmersionsraums zwischen dem bewegbaren Element und dem Objekt gebildet ist, und
wobei das bewegbare Element sich in einer Ebene senkrecht zu einer optischen Achse des optischen Elements bewegt und sich relativ zur optischen Achse bewegt, sodass eine relative Bewegungsgeschwindigkeit in Bezug auf das Objekt verringert wird.

24. Belichtungsverfahren zum Belichten eines Substrats mit Belichtungslicht über eine Flüssigkeit, wobei das Verfahren umfasst:
Emittieren von Belichtungslicht von einer emittierenden Fläche eines optischen Elements;
Bilden eines Flüssigkeitsimmersionsraums der Flüssigkeit auf einem Objekt, das unterhalb des optischen Elements bewegbar ist, mit einem Flüssigkeitsimmersionselement, das bei zumindest einem Abschnitt einer Umgebung eines Strahlengangs des Belichtungslichts angeordnet ist,
welches Flüssigkeitsimmersionselement ein bewegbares Element einschließlich eines Rückgewinnteils und eines ersten Kanals aufweist, wobei der Rückgewinnteil dem Objekt gegenüberliegt und zumindest einen Abschnitt der Flüssigkeit im Flüssigkeitsimmersionsraum rückgewinnt, wobei der erste Kanal die Flüssigkeit vom Rückgewinnteil transportiert,
eine Verbindungsvorrichtung, die (i) zumindest einen Abschnitt aufweist, der dem bewegbaren Element zugewandt ist, (ii) einen zweiten Kanal aufweist, der die Flüssigkeit vom ersten Kanal transportiert, und (iii) zumindest einen Abschnitt davon aufweist, der sich relativ in Bezug auf das bewegbare Element bewegt,
wobei der erste Kanal mit einem dritten Kanal über den zweiten Kanal verbunden ist, wobei der dritte Kanal in Verbindung mit einer Flüssigkeitsrückgewinnvorrichtung steht; und
Belichten des Substrats mit dem Belichtungslicht über die Flüssigkeit im Flüssigkeitsimmersionsraum, der einen Abschnitt einer oberen Fläche des Substrats abdeckt,
wobei ein Abschnitt des Flüssigkeitsimmersionsraums zwischen dem bewegbaren Element und dem Objekt gebildet ist, und
wobei das bewegbare Element in einer Ebene senkrecht zu einer optischen Achse des optischen Elements bewegt wird und relativ zur optischen Achse bewegt wird, sodass eine relative Bewegungsgeschwindigkeit in Bezug auf das Objekt verringert wird.

25. Vorrichtungsherstellungsverfahren, umfassend:
Belichten eines Substrats unter Verwendung des Belichtungsverfahrens nach Anspruch 23 oder 24 oder der Belichtungsvorrichtung nach einem der Ansprüche 1 bis 22; und
Entwickeln des belichteten Substrats.

## Revendications

1. Appareil d'exposition (EX) pour exposer un substrat (P) à l'aide d'une lumière d'exposition (EL) via un liquide (LQ), l'appareil d'exposition comprenant :
un élément optique (13) ayant une surface émettrice (12) à partir de laquelle la lumière d'exposition est émise ;
un élément d'immersion liquide (5) qui est disposé au niveau d'au moins une partie d'entourage d'un chemin optique (K) de la lumière d'exposition, qui est configuré pour former un espace d'immersion liquide (LS) du liquide sur un objet pouvant se déplacer sous l'élément optique, et qui a un élément mobile (100) incluant une partie de récupération (27) et un premier canal (27R), la partie de récupération étant opposée à l'objet et configurée pour récupérer au moins une partie du liquide dans l'espace d'immersion liquide, le premier canal étant configuré pour faire s'écouler le liquide à partir de la partie de récupération ; et
un élément de déformation (61) qui (i) est connecté à l'élément mobile, (ii) a un deuxième canal (62) configuré pour faire s'écouler le liquide à partir du premier canal, et (iii) a au moins une partie qui est déformable,
dans lequel l'appareil est configuré pour exposer le substrat à l'aide de la lumière d'exposition via le liquide dans l'espace d'immersion liquide recouvrant une partie d'une surface supérieure du substrat,
dans lequel une partie de l'espace d'immersion liquide est formée entre l'élément mobile et l'objet, et
dans lequel l'élément mobile est agencé pour se déplacer dans un plan perpendiculaire à un axe optique de l'élément optique et pour se déplacer par rapport à l'axe optique de sorte qu'une vitesse de déplacement relative par rapport à l'objet est diminuée.

2. Appareil d'exposition selon la revendication 1,
dans lequel l'élément de déformation est élastiquement déformable dans une plage de déplacement dans laquelle l'élément mobile est agencé pour se déplacer.

3. Appareil d'exposition selon la revendication 1 ou 2, dans lequel
l'élément de déformation est déformable dans une direction de déplacement de l'élément mobile.

4. Appareil d'exposition selon l'une quelconque des revendications 1 à 3, dans lequel l'élément de déformation comprend un élément de tube (61) ayant une zone flexible au niveau d'au moins une partie de celui-ci.

5. Appareil d'exposition selon l'une quelconque des revendications 1 à 4, comprenant en outre :
un cadre de référence (8A) configuré pour supporter l'élément optique ;
un cadre de support (53, 54) configuré pour supporter au moins une partie de l'élément d'immersion liquide ; et
un cadre d'appareil (8B) configuré pour supporter le cadre de référence et le cadre de support,
dans lequel l'élément de déformation est supporté par le cadre de support.

6. Appareil d'exposition selon la revendication 5, comprenant en outre :
un isolateur de vibrations (10) agencé entre le cadre de référence et le cadre d'appareil.

7. Appareil d'exposition selon la revendication 5 ou 6, comprenant en outre :
un autre isolateur de vibrations (55), dont au moins une partie est agencée entre le cadre de support et le cadre d'appareil.

8. Appareil d'exposition (EX) pour exposer un substrat (P) à l'aide d'une lumière d'exposition (EL) via un liquide (LQ), l'appareil d'exposition comprenant :
un élément optique (13) ayant une surface émettrice (12) à partir de laquelle la lumière d'exposition est émise ;
un élément d'immersion liquide (5) qui est disposé au niveau d'au moins une partie d'entourage d'un chemin optique (K) de la lumière d'exposition, qui est configuré pour former un espace d'immersion liquide (LS) du liquide sur un objet pouvant se déplacer sous l'élément optique, et qui a un élément mobile (100) incluant une partie de récupération (27) et un premier canal (27R), la partie de récupération étant opposée à l'objet et configurée pour récupérer au moins une partie du liquide dans l'espace d'immersion liquide, le premier canal étant configuré pour faire s'écouler le liquide à partir de la partie de récupération ; et
un dispositif de connexion (70) qui (i) est configuré pour avoir au moins une partie de celui-ci qui fait face à l'élément mobile, (ii) a un deuxième canal (62F) configuré pour faire s'écouler le liquide à partir du premier canal, et (iii) est configuré pour avoir au moins une partie de celui-ci qui est mobile de manière relative par rapport à l'élément mobile,
dans lequel le premier canal est connecté à un troisième canal (63FR) via le deuxième canal, le troisième canal étant en communication avec un appareil de récupération de liquide (27C)
dans lequel le substrat est exposé à l'aide de la lumière d'exposition via le liquide dans l'espace d'immersion liquide recouvrant une partie d'une surface supérieure du substrat,
dans lequel une partie de l'espace d'immersion liquide est formée entre l'élément mobile et l'objet, et
dans lequel l'élément mobile est agencé pour se déplacer dans un plan perpendiculaire à un axe optique de l'élément optique et est agencé pour se déplacer par rapport à l'axe optique de sorte qu'une vitesse de déplacement relative par rapport à l'objet est diminuée.

9. Appareil d'exposition selon la revendication 8,
dans lequel le dispositif de connexion a un mécanisme de liaison (70R) comprenant (i) un premier élément de liaison (71) qui est connecté à l'élément mobile via une première section de joint (711) et dans lequel une première partie (621F) du deuxième canal est formée, et (ii) un second élément de liaison (72) qui est connecté au premier élément de liaison via une seconde section de joint (712) et dans lequel une seconde partie (622F) du deuxième canal est formée.

10. Appareil d'exposition selon la revendication 8 ou 9, comprenant en outre :
un cadre de référence (8A) configuré pour supporter l'élément optique ;
un cadre de support (53, 54) configuré pour supporter au moins une partie de l'élément d'immersion liquide ; et
un cadre d'appareil (8B) configuré pour supporter le cadre de référence et le cadre de support,
dans lequel le dispositif de connexion est supporté par le cadre de support.

11. Appareil d'exposition selon la revendication 9, comprenant en outre :
un isolateur de vibrations (10) agencé entre le cadre de référence et le cadre d'appareil.

12. Appareil d'exposition selon la revendication 9 ou 10, comprenant en outre :
un autre isolateur de vibrations (55) dont au moins une partie est agencée entre le cadre de support et le cadre d'appareil.

13. Appareil d'exposition selon l'une quelconque des revendications 1 à 11,
dans lequel l'élément mobile est mobile dans un état dans lequel l'espace d'immersion liquide est formé.

14. Appareil d'exposition selon l'une quelconque des revendications 1 à 12,
dans lequel l'élément mobile est mobile pendant au moins une partie d'une période au cours de laquelle la lumière d'exposition est émise à partir de la surface émettrice.

15. Appareil d'exposition selon l'une quelconque des revendications 1 à 13,
dans lequel l'élément mobile est déplacé de sorte qu'une vitesse de déplacement relative entre l'élément mobile et l'objet devient inférieure à une vitesse de déplacement relative entre l'élément optique et l'objet.

16. Appareil d'exposition selon l'une quelconque des revendications 1 à 15,
dans lequel l'élément mobile est mobile dans la même direction que celle dans laquelle l'objet est déplacé pour diminuer la vitesse de déplacement relative entre l'élément mobile et l'objet.

17. Appareil d'exposition selon l'une quelconque des revendications 1 à 16,
dans lequel l'objet comprend le substrat,
dans un état dans lequel l'espace d'immersion liquide est formé, le substrat se déplace le long d'un premier trajet (Tp1) et ensuite se déplace le long d'un deuxième trajet (Tp2) dans un plan sensiblement perpendiculaire à un axe optique de l'élément optique, un déplacement du substrat dans le premier trajet comprend un déplacement dans une première direction sensiblement parallèle à un premier axe (Y) dans le plan, et un déplacement du substrat dans le deuxième trajet comprend un déplacement dans une deuxième direction sensiblement parallèle à un deuxième axe (X) perpendiculaire au premier axe dans le plan et un déplacement dans une troisième direction sensiblement parallèle à un troisième axe perpendiculaire au deuxième axe dans le plan.

18. Appareil d'exposition selon la revendication 17,
dans lequel la lumière d'exposition est rayonnée vers une région de frappe du substrat via le liquide dans l'espace d'immersion liquide lorsque le substrat se déplace le long du premier trajet, et la lumière d'exposition n'est pas rayonnée lorsque le substrat se déplace le long du deuxième trajet.

19. Appareil d'exposition selon la revendication 17 ou 18,
dans lequel le substrat se déplace le long du deuxième trajet et se déplace le long d'un troisième trajet,
dans le troisième trajet, un déplacement du substrat comprend un déplacement dans la troisième direction opposée à la première direction, et
l'élément mobile se déplace dans une quatrième direction opposée à la deuxième direction pendant au moins une partie d'une période au cours de laquelle le substrat se déplace le long du troisième trajet.

20. Appareil d'exposition selon l'une quelconque des revendications 1 à 19
dans lequel l'élément d'immersion liquide a un premier élément (21) qui est disposé au moins dans une partie d'entourage de l'élément optique, et un second élément (22) qui est disposé pour être opposé à l'objet et qui est configuré pour être mobile par rapport au premier élément, et
l'élément mobile comprend le second élément.

21. Appareil d'exposition selon la revendication 20,
dans lequel chacun parmi le premier élément et le second élément a une ouverture (34, 35) à travers laquelle le faisceau d'exposition est autorisé à passer.

22. Appareil d'exposition selon la revendication 20 ou 21,
dans lequel une partie d'alimentation en liquide (31) via laquelle le liquide est alimenté est formée à au moins l'un parmi le premier élément et le second élément.

23. Procédé d'exposition pour exposer un substrat à l'aide d'une lumière d'exposition via un liquide, le procédé comprenant les étapes consistant à :
émettre une lumière d'exposition à partir d'une surface émettrice d'un élément optique ;
former un espace d'immersion liquide du liquide sur un objet pouvant se déplacer sous l'élément optique avec un élément d'immersion liquide qui est agencé au niveau d'au moins une partie d'entourage d'un chemin optique de la lumière d'exposition,
lequel élément d'immersion liquide comporte un élément mobile incluant une partie de récupération et un premier canal, la partie de récupération étant opposée à l'objet et récupérant au moins une partie du liquide dans l'espace d'immersion liquide, le premier canal faisant s'écouler le liquide à partir de la partie de récupération,
un élément de déformation (i) étant connecté à l'élément mobile, (ii) ayant un deuxième canal faisant s'écouler le liquide à partir du premier canal, et (iii) ayant au moins une partie qui se déforme ;
exposer le substrat à l'aide de la lumière d'exposition via le liquide dans l'espace d'immersion liquide recouvrant une partie d'une surface supérieure du substrat,
dans lequel une partie de l'espace d'immersion liquide est formée entre l'élément mobile et l'objet, et
dans lequel l'élément mobile se déplace dans un plan perpendiculaire à un axe optique de l'élément optique et se déplace par rapport à l'axe optique de sorte qu'une vitesse de déplacement relative par rapport à l'objet est diminuée.

24. Procédé d'exposition pour exposer un substrat à l'aide d'une lumière d'exposition via un liquide, le procédé comprenant les étapes consistant à :
émettre une lumière d'exposition à partir d'une surface émettrice d'un élément optique ;
former un espace d'immersion liquide du liquide sur un objet pouvant se déplacer sous l'élément optique avec un élément d'immersion liquide qui est agencé au niveau d'au moins une partie d'entourage d'un chemin optique de la lumière d'exposition,
lequel élément d'immersion liquide a un élément mobile incluant une partie de récupération et un premier canal, la partie de récupération étant opposée à l'objet et récupérant au moins une partie du liquide dans l'espace d'immersion liquide, le premier canal faisant s'écouler le liquide à partir de la partie de récupération,
un dispositif de connexion (i) ayant au moins une partie de celui-ci qui fait face à l'élément mobile, (iii) ayant un deuxième canal qui fait s'écouler le liquide à partir du premier canal, et (iii) ayant au moins une partie de celui-ci qui se déplace de manière relative par rapport à l'élément mobile,
le premier canal étant connecté à un troisième canal via le deuxième canal, le troisième canal étant en communication avec un appareil de récupération de liquide ; et
exposer le substrat à l'aide de la lumière d'exposition via le liquide dans l'espace d'immersion liquide recouvrant une partie d'une surface supérieure du substrat,
dans lequel une partie de l'espace d'immersion liquide est formée entre l'élément mobile et l'objet, et
dans lequel l'élément mobile est déplacé dans un plan perpendiculaire à un axe optique de l'élément optique et est déplacé par rapport à l'axe optique de sorte qu'une vitesse de déplacement relative par rapport à l'objet est diminuée.

25. Procédé de fabrication de dispositif comprenant :
l'exposition d'un substrat en utilisant le procédé d'exposition selon la revendication 23 ou 24 ou l'appareil d'exposition selon l'une quelconque des revendications 1 à 22 ; et
le développement du substrat exposé.
